# EUROPEAN PATENT SPECIFICATION

(11) **EP 1 265 077 B1**
(45) Date of publication and mention of the grant of the patent: **19.09.2007**
(21) Application number: 02011564.8
(22) Date of filing: 24.05.2002
(51) Int. Cl.: G01R 31/04

(54) **System and method for testing harnesses**
System und Verfahren zur Kabelbaumprüfung
Système et méthode de teste de harnais de câbles

(30) Priority: 30.05.2001 JP 2001163089; 30.05.2001 JP 2001163090
(43) Date of publication of application: 11.12.2002
(60) Divisional application: 06017196.4
(73) Proprietor: Sumitomo Wiring Systems, Ltd., Yokkaichi-City, Mie, 510-8503 (JP)
(72) Inventor: Taniguchi, Yoshikazu c/o Sumitomo Wiring Sys., Ltd, Yokkaichi-city, Mie 510-8503 (JP); Mori, Setsurou, c/o Holon Corporation, Ritto-city, Shiga-pref. 520-3024 (JP)
(74) Representative: Müller-Boré & Partner Patentanwälte

(56) References cited:
- WO-A-00/33517
- US-A- 5 448 574

## Description

The present invention relates to a processing system for a wiring harness, a method for testing an electrical connection of a wiring harness, a computer-readable storage medium storing thereon a computer program and a wire connection assisting system.

In general, a wiring harness is an electrical wiring system forming a complicated network, and an electrical connection test is conducted during its production process to discriminate whether or not the constructed network is satisfactory.

A known processing system for such a wiring harness is constructed such that a master unit having an electrical connection testing function and connector units to be connected with the wiring harness are so connected as to enable a multiplexing communication (e.g. Japanese Unexamined Patent Publications Nos. 6-258371 and 10-132885 and Japanese Unexamined Utility Model Publication No. 6-72066).

In such a prior art, the wiring harness and the master unit are electrically connected via adapters provided between the wiring harness and the connector units. The multiplexing communication between the master unit and the connector unit is conducted by a so-called CSMA/CD (carrier sense multiple access with collision detection) method, and "survival arbitration" for making a judgment based on bit lengths of two signals is adopted in the case that data are simultaneously outputted from a plurality of units. The respective connector units are provided with a microprocessor in order to enable such a communication control and electrical connection tests.

In recent years, it has been demanded to test an electrical connection of the wiring harness substantially every time a harness-forming wire (wire cut to a specified length and having terminals connected with the opposite ends thereof or a subassembly connected with connector(s)) which is an element of the wiring harness is connected during the production of the wiring harness. Such an electrical connection test needs to be conducted in real time every time an operator connects the harness-forming wire.

However, since the survival arbitration based on the CSMA/CD method has been adopted as a communication method in the case that such an electrical connection test is conducted by the above testing device, communication conditions need to be established between the master unit and the connector units. Further, since there is a waiting time upon a collision of the signals, a response time elapsing between the end of the connecting operation and the end of the electrical connection test becomes longer, resulting in a longer waiting time of the operator. Therefore, the above communication method was not practical.

On the other hand, if an attempt is made to process the signals from the master unit and the connector units by a method other than the multiplexing communication, signal lines necessary for the electrical connection test cannot be physically laid on an assembling board, making it impossible to perform connecting operations for a large-size wiring harness, which has been demanded in recent years, on a compact assembling board.

Moreover, there is a striking movement of installing more and more electronic equipments in vehicles, and wiring harnesses to be laid in the vehicles are getting larger while having complicated branch wires. Thus, a method for dividing a wiring harness into several subassemblies and assembling the respective subassemblies into the wiring harness on a wire laying board of a main line has been generally adopted in the production process of the wiring harness.

As a system for carrying out the above method is known a wire connection assisting system provided with a plurality of wire supplying portions for accommodating terminal-provided wires cut to specified lengths and formed by connecting terminals with the opposite ends of insulated wires while sorting them according to their kinds, assembling boards on which the terminal-provided wires taken out from the wire supplying portions are connected, connector holders standing on the assembling boards and adapted to hold connectors to be connected with the terminal-provided wires taken out from the wire supplying portions, and a wire connection instructing mechanism for instructing the wires to be connected with contacts of the connectors held in the respective connector holders.

Since the number of circuits of the subassembly to be formed has been increased (e.g. 200 to 300 circuits or 960 points or contacts) in recent years, there has been a demand to distribute the wire supplying portions at a plurality of stations and to convey the assembling boards from upstream-side stations to downstream-side stations. In such a case, as the wire supplying portions are distributed, wire-side connection instruction means need to be distributed at the plurality of stations, and the wire-side connection instruction means provided at the respective stations need to instruct a wire connection in cooperation with detecting elements of the connector holders.

In order to realize such a cooperation, a master unit has been provided for each wire supplying portion and connected with the respective detecting elements of the connector holders via an interface connector provided on the assembling board. However, in such a case, it is cumbersome to connect and disconnect the interface connector, causing a poor operability.

Further, in the case of a so-called mixed production of producing many kinds of wiring harnesses in the same conveyor line, it has been necessary to input pieces of production information of the respective wiring harnesses in all the master units provided at the respective wire supplying portions and to renew these pieces of information. Thus, a considerable mount of operation has been necessary as a preparation of the mixed production.

Further, in the case that a problem such as a defective product or a trouble occurs on any of a plurality of assembling boards, the connecting operations on the other assembling boards may be adversely affected unless a problem information is transmitted to the respective master units since the master units are provided at the wire supplying portions. Accordingly, a system for enabling a communication between the master units has been required to prevent such a problem.

On the other hand, it is desirable to provide the master unit on the assembling board and to enable an information of a single database built in this master unit to be shared by the respective connection instructing means. However, since it has been necessary to establish a protocol between the master unit and the respective connection instructing means in a general multiplexing communication system, it has taken time to transmit data and, therefore, a problem of being incapable of executing practical controls has been unavoidable.

US 5 448 574 discloses a detection system for abnormal cable connections in communication apparatuses in which a first level unit, a second level unit and a third level unit are hierarchically arranged and these units are connected to one another by multicore cables. One of the cores is used as a monitoring core and the first level unit sends out a probe signal generated by sampling the digital signals. The probe signal is multiplexed on a time-division basis.

In view of the problems residing in the prior art, an object of the present invention is to improve operability of production of wiring harnesses, in particular by enabling an electrical connection test to be performed within a practical response time when the electrical connection test is conducted preferably substantially every time a harness-forming wire is connected on a compact assembling board and in particular by allowing to easily, precisely and continuously perform operations of connecting wires of a wiring harness to form a large-scale circuitry on the same assembling board.

This object is solved according to the invention by the features of independent claim 1. Preferred embodiments of the invention are subject of the dependent claims.

According to the invention, there is provided a processing system for a wiring harness provided in a production line for producing the wiring harness by conveying a connection board from one to another of a plurality of stations and connecting harness-forming wires to form the wiring harness on the connection board, and having a function of, preferably substantially every time the harness-forming wire is connected, testing an electrical connection at least part of a network of the wiring harness including the connected harness-forming wire, comprising:
a master unit for conducting an electrical connection test for the wiring harness being produced,
a plurality of connector units which are at least temporarily so connected with the master unit as to enable a multiplexing communication and which can exchange signals with at least part of the wiring harness,
a multiplexing communication path for connecting the master unit and the respective connector units so as to enable the multiplexing communication therebetween,
wherein:
different node addresses are set for the master unit and the respective connector units,
each of the master unit and the connector units comprises a multiplexing communication controller adopting a perfect time-division multiplexing communication method according to which tokens are given to the master unit and the connector units by a time-division technique based on timing bit sets issued at specified intervals from any of the units and the node addresses,
the master unit preferably comprises:
   a read data storage means for storing a connection information of the network formed by the newly connected harness-forming wire as a read data based on a data packet sent from the connector unit via the multiplexing communication with the connector unit by the perfect time-division multiplexing communication method,
   a test standard data storage means for storing a test standard data as a standard of the electrical connection test, and
   preferably a discriminating means for discriminating whether or not contacts of the network are properly connected by comparing the read data and the test standard data,
      wherein the test standard data storage means stores an electrical connection test information of the network built by the harness-forming wires as the test standard data up to a final stage for each harness-forming wire, and
      the discriminating means preferably discriminates whether or not the network is satisfactory up to the last stage based on the test standard data every time the harness-forming wire is connected in the production process of the wiring harness being tested.

Accordingly, the tokens are given to the respective units by the time-division technique based on the timing bit sets issued at the specified intervals from any of the units and the node addresses when the electrical connection of the network including the connected harness-forming wire is tested every time the harness-forming wire is newly connected in the process of connecting the harness-forming wires as elements of the wiring harness on the connection board being conveyed from one to another of the plurality of stations. Thus, it is not necessary to establish communication conditions between the units, and the data can be transmitted and received between the units without a protocol thus improving operability. Therefore, a response time elapsing between the end of the electrical connection test and the end of the operation of the connecting the harness-forming wire can be remarkably shortened, and the next connecting operation can follow without letting an operator spend a waiting time.

Since it is preferably not necessary to establish communication conditions between the master unit and the connector units, each connector unit needs not be provided with a microprocessor. Thus, a simple and inexpensive hardware construction can be adopted. Further, since a protocol-free communication mode can be adopted, it is not necessary to develop a software for establishing a protocol between the nodes, which contributes to a cost reduction.

By conducting the multiplexing communication between the master unit and the connector units, wiring between the respective units can be simplified, and the electrical connection test can be conducted on a compact board even if the wiring harness has a relatively large number of circuits (e.g. having 960 contacts).

By adopting the perfect time-division multiplexing communication method, the multiplexing communication between the respective units is enabled only by setting the timing bit sets outputted at the specified intervals and the node addresses. Thus, the connector units can be easily increased and decreased, and a change in the hardware specification of the wiring harness can be easily dealt with.

In the present invention, the "harness-forming wire" may be a terminal-provided wire formed by connecting terminals at the opposite ends of an insulated wire or a partial harness formed by connecting a plurality of terminal-provided wires.

In a preferred embodiment of the invention, a connector-side connection instructing means which can indicate a connection end of the harness-forming wire is associated with, preferably provided in each connector holder, and
the master unit further comprises a connection assisting data storage means for storing a connection assisting data for the wiring harness being produced, and a connection instruction control means for controlling a connection instruction by the connector-side connection instructing means via the multiplexing communication controller based on the read data and the connection assisting data.

In this embodiment, a connected state of the harness-forming wire with the connector held in the connector holder can be read as the connection information by the master unit by conducting the multiplexing communication between the master unit and the connector unit, and the connector-side connection instructing means of the connector holder connected with this connector unit can be controlled by instructing a connection assistance to the connector unit in accordance with the read connection information.

According to the invention, there is also provided a method for testing an electrical connection of a network of a wiring harness including harness-forming wires preferably substantially every time the harness-forming wire is connected, the method preferably using a processing system according to the invention or an embodiment thereof and being adoptable in a production line of producing the wiring harness by conveying a connection board from one to another of a plurality of stations and connecting the harness-forming wires to form the wiring harness on the connection board, comprising the steps of:
setting different node addresses for a master unit for conducting an electrical connection test for the wiring harness being produced and a plurality of connector units for connecting the master unit with the wiring harness,
giving tokens to the respective units by a time-division technique based on timing bit sets issued at specified intervals from any of the units and the node addresses according to a perfect time-division multiplexing communication method, and
discriminating whether or not the network is satisfactory up to a final state by the perfect time-division multiplexing communication method preferably substantially every the harness-forming wire is connected in the production process of the wiring harness being tested.

According to the invention, there is still further provided a computer-readable storage medium storing thereon a computer program, which comprises computer-readable program means for causing a computer to control an execution of a method for testing an electrical connection of a network of a wiring harness including harness-forming wires according to the invention or an embodiment thereof (when run on a computer). According to a further preferred aspect of the invention, there is provided a computer program and a computer program product directly loadable into the internal memory of a digital computer, comprising software code portions for performing the steps of a method for testing an electrical connection of a network of a wiring harness including harness-forming wires according to the invention or an embodiment thereof, when said computer program or computer program product is run on a computer.

According to the invention, there is still further provided a wire connection assisting system, preferably including a processing system according to the invention or an embodiment thereof, comprising:
a wire supplying portion for accommodating terminal-provided wires formed preferably by connecting terminals with the opposite ends of insulated wires cut to specified lengths while sorting the terminal-provided wires according to their kinds beforehand,
an assembling board on which the terminal-provided wires taken out from the wire supplying portion are to be connected,
connector holders provided, preferably standing on the assembling board and each including a connector accommodating portion for holding a connector to be connected with the terminal-provided wire taken out from the wire supplying portion and a detecting element electrically connectable with a terminal of the terminal-provided wires inserted into the connector at least partly accommodated in the connector accommodating portion,
a wire-side connection instructing means provided at the wire supplying portion for given an instruction of taking out the wire or a specific (predetermined or predeterminable) wire accommodated in the wire supplying portion,
connector-side connection instructing means provided in correspondence with the respective connector holders for displaying a connection end corresponding to the connector with which the taken-out terminal-provided wire is to be connected,
a master unit provided on the assembling board to be at least temporarily electrically connectable with the respective detecting elements for controlling the respective connection instructing means,
a wire-side node unit at least temporarily connectable or connected with the master unit in such a manner as to enable a multiplexing communication and adapted to drive the wire-side connection instructing means based on a control of the master unit,
a connector-side node unit at least temporarily connectable or connected with the master unit in such a manner as to enable a multiplexing communication and adapted to control the detecting elements of the connector holders and the wire-side connection instructing means based on the control of the master unit,
a multiplexing communication control system for connecting the master unit and the node unit as nodes so as to enable the multiplexing communication therebetween, and
wherein preferably the connection of harness-forming wires to form a wiring harness being assisted by controlling the respective connection instructing means based on an information of a single database built in the master unit and a connection information of the harness-forming wires to be connected with the connectors on the assembling board,
wherein the multiplexing communication system further preferably comprises:
a node address setting means for setting different node addresses for the respective nodes,
a token issuing means for issuing timing bit sets as token signals at specified intervals, and
a token reception controller for giving the tokens to the respective nodes by a time-division technique based on the timing bit sets issued by the token issuing means and the node addresses.

Accordingly, a perfect time-division multiplexing communication method according to which the tokens are given to the respective nodes (the master unit and the respective node units) based on the timing bit sets as the token signals issued at the specified intervals and the node addresses set for the respective nodes upon controlling the respective connection instructing means based on the information of the single database built in the master unit is adopted by providing the master unit on the assembling board and conducting the multiplexing communication with the respective connection instructing means. Thus, it is not necessary to establish the communication conditions between the nodes for transmitting and receiving the data, and the data can be transmitted and received preferably without a protocol. This remarkably shortens a response time between the nodes for transmitting and receiving the data. Thus, even if the wires are instructed to the respective connection instructing means in a complicated manner, these connection instructing means can be quickly controlled at a practical speed thus improving operability. Since this enables a unitary administration of a connection assisting information and an electrical connection test information of a large-size wiring harness by the master unit using the single database, the data can be more easily administered and renewed. Further, since the protocol-free communication mode can be preferably adopted, it is not necessary to develop a software for establishing a protocol between the nodes, which contributes to a cost reduction.

In the present invention, the "harness-forming wire" may be a terminal-provided wire formed by connecting terminals at the opposite ends of an insulated wire or a partial harness formed by connecting a plurality of terminal-provided wires.

In a further preferred embodiment of the invention, the master unit has a function of testing an electrical connection of a network including the connected harness-forming wire substantially every time the harness-forming wire is connected with the connector held in the connector holder, and causes the respective connection instructing means to assist a next connecting operation only in the case of a success in an electrical connection test.

In such a case, since the electrical connection test is conducted every time the connecting operation is performed, an erroneous connection can be detected by a real-time response, thereby preventing a defective product from being conveyed to a later step. Further, by adopting the perfect time-division multiplexing communication method, a time required for the electrical connection test can be remarkably shortened. Thus, a processing time between one set of the connecting operation and the electrical connection testing operation and the next set can be shortened, with the result that an operator needs not spend a waiting time.

In another preferred embodiment of the invention, the wire supplying portion is provided at each of a plurality of stations installed along a conveyance path along which the assembling board is conveyed, and the master unit tests the electrical connection up to the last stage of the production process of the wiring harness being tested.

This arrangement enables the wire connection to be seamlessly instructed from the first station to the last station even if the wire supplying portion is installed at a plurality of stations. Therefore, even if the operator is changed between the respective stations or the operation is interrupted, there is no variation in the quality of the connecting operations.

A so-called mixed production can be made more easily by providing the master unit on the assembling board. In addition, since an occurrence of a trouble or a defect on any of the assembling boards has no influence on the controls on the other assembling boards in the case of the mixed production, a risk of such an influence can be minimized.

Further, since the information of the single database is shared and the connecting operations are assisted at all the stations, it is not necessary to provide a means for preventing a connection error of the operator by sorting the insulated wires forming the products by colors. As a result, the kinds of the insulated wires as materials can be reduced and the production cost can be reduced.

In still another preferred embodiment, the wire-side node unit comprises, preferably is formed by a gateway which can conduct a multiplexing communication with an external network.

With such a wire-side node unit, a communication line built with the master unit as a center can be so connected with external networks as to enable a multiplexing communication, thereby enabling various operations to be performed. For example, the data can be remotely taught to and changed in a storage means of the master unit by way of an external network. Further, since the behavior of the wire connection assisting system having the master unit as a center can be monitored as it is via the external network, supplementary functions of the wire connection assisting system such as maintenance and warnings can be added.

Preferably, the assembling board comprises:
a plurality of temporarily holding jigs for temporarily holding the other ends of the terminal-provided wires determined as free terminals to be connected when the subassembly is assembled into the wiring harness, and
the connector-side node unit is provided for each of the temporarily holding jigs and is connected with a terminus end instructing means for instructing the temporarily holding jig preferably when the other end as the free terminal is brought into contact with a grounding member.

With such an assembling board, in the case that the subassembly includes so-called "free terminals" to be connected when the subassembly is assembled into the wiring harness, the individual free terminals can be respectively supported at the suitable temporarily holding positions when being temporarily held at a plurality of positions, with the result that the wire connecting operation can be efficiently performed.

These and other objects, features and advantages of the present invention will become more apparent upon reading of the following detailed description of preferred embodiments and accompanying drawings. It should be understood that even though embodiments are separately described, single features thereof may be combined to additional embodiments.
FIG. 1 is a perspective view diagrammatically showing a schematic construction of a production line adopting a wire connection assisting system according to one embodiment of the invention,
FIG. 2 is a perspective view showing an essential portion of FIG. 1,
FIG. 3 is a perspective view enlargedly showing an essential portion of a wire connection instructing mechanism of FIG. 1,
FIG. 4A is a schematic section enlargedly showing the essential portion of the wire connection instructing mechanism of FIG. 1,
FIG. 4B is a schematic section through a preferred probe for use with the wire connection instructing mechanism of FIG. 1,
FIGS. 5(A), 5(B) and 5(C) are a front view, a right side view and a left side view showing the external construction of a connector unit,
FIG. 6 is a block diagram showing the connector unit and elements connected therewith according to the embodiment of FIG. 1,
FIGS. 7(A), 7(B), 7(C) and 7(D) a front view, a right side view, a plan view and a bottom view showing the external construction of a master unit,
FIG. 8 is a block diagram showing a connected state of the master unit with the connector units and channel unit,
FIG. 9 is a data table showing data used in this embodiment in a list format,
FIGS. 10(A), 10(B), 10(C), 10(D) and 10(E) are a front view, a right side view, a left side view, a plan view and a bottom view showing the external construction of the channel unit,
FIG. 11 is a block diagram showing a wired state of the channel unit,
FIG. 12 is a block diagram showing multiplexing communication controllers of the master unit, the connector units and the channel units in detail,
FIG. 13 is a diagram showing a state of a perfect time-division multiplexing communication by the master unit according to the invention,
FIG. 14 is a flow chart showing the detail of a connecting process according to the invention,
FIG. 15 is a flow chart showing the detail of the connecting process according to the invention,
FIG. 16 is a flow chart showing the detail of the connecting process according to the invention,
FIG. 17 is a flow chart showing the detail of the connecting process according to the invention, and
FIG. 18 is a timing chart showing an example of specific signal processing when a multiplexing communication method according to the embodiment is applied to an electrical connection test.

Hereinafter, a preferred embodiment of the present invention is described in detail with reference to the accompanying drawings.

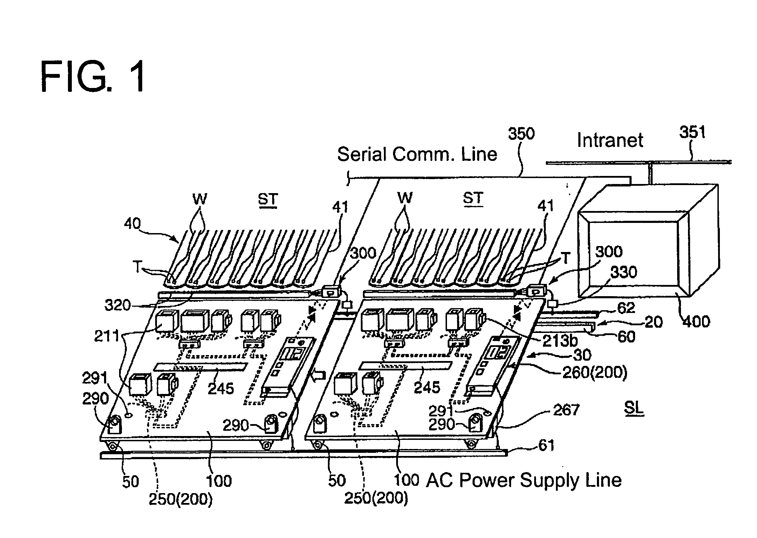

FIG. 1 is a perspective view diagrammatically showing a schematic construction of a production line adopting a wire connection assisting system 10 according to one embodiment of the present invention.

First, with reference to FIG. 1, the shown production line includes an unillustrated main line for finishing a final wiring harness and a plurality of subassembly lines SL connected with the main line in a branched manner. The wire connection assisting system 10 of this embodiment is applied to the subassembly lines SL.

Each subassembly line SL includes a conveyor 20 for producing a subassembly, an assembly board unit 30 conveyed by the conveyor 20, and a wire supply table 40 as a wire supplying portion for stocking terminal-provided wires W as materials of the subassembly.

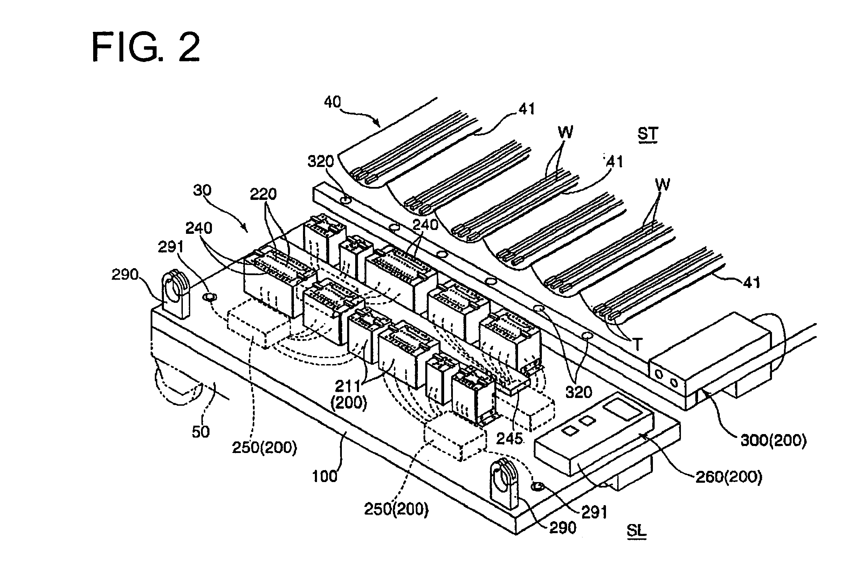

The conveyor 20 is successively moved a preferably hand-pushed conveyance truck 50 to several stations ST set in the subassembly line SL, so that a specified processing can be applied at each station ST. In the shown example, the assembling board unit 30 (see FIG. 2) to be described later is carried by the hand-pushed conveyance truck 50. A specified subassembly is produced by inserting the terminal-provided wires W into corresponding connectors C at the respective stations ST.

Next, a multitude of channel sections 41 preferably having a substantially rectangular cross section are provided in the wire supply table 40. This wire supply table 40 is used to sort all kinds of terminal-provided wires W necessary to form a subassembly into several groups in accordance with a production procedure, and is allotted to each of a plurality of stations ST set in the subassembly line SL from an upstream side in accordance with the production procedure.

The respective channel sections 41 are adapted to stock a plurality of kinds of terminal-provided wires W while sorting them according to the kind.

In the shown example, each wire supply table 40 is provided with a channel unit 300 as a wire-side node unit which is part of a terminal insertion assisting unit 200 of this embodiment, and guide lamps 320 as a wire-side connection instructing means are mounted near take-out openings of the respective channel sections 41 in one-to-one correspondence with the channel sections 41 and connected with the corresponding channel unit 300. By selectively turning the guide lamps 320 on, the kind of the terminal-provided wire W to be taken out by an operator can be specified or instructed or displayed.

Next, each hand-pushed conveyance truck 50 is manually conveyed along a pair of rails 60 (only one rail is shown in FIG. 1) provided in the conveyor 20 to be moved to a plurality of stations ST set along the rails 60 from upstream side to downstream side. On the inner sides of the rails 60 are provided a power supply line 61 for supplying a power to control units placed on each hand-pushed conveyance truck 50 as described later and a power supply line 62 for supplying a power to the channel unit 300. Although schematically shown in detail, a measure to prevent an electric shock is provided for these power supply lines 61, 62 by the rails 60 and unillustrated covers.

Next, with reference to FIG. 2, each assembling board unit 30 is provided with an assembling board 100 fixed or fixable or moutable to the hand-pushed conveyance truck 50.

The assembling board 100 is a work table on which the operator connects the wires. This assembling board 100 is provided with connector holders 211, probes 220 as detecting elements provided in the connector holders 211, guide lamps or indicators 240 as connector-side connection instructing means attached or associated to the connector holders 211 in correspondence with the probes 220, connector units 250 connected with the probes 220 and the guide lamps 240, and a master unit 260 connected with the connector units 250, the elements 211, 220, 240, 250, 260 forming or being part of the terminal insertion assisting unit 200 of this embodiment.

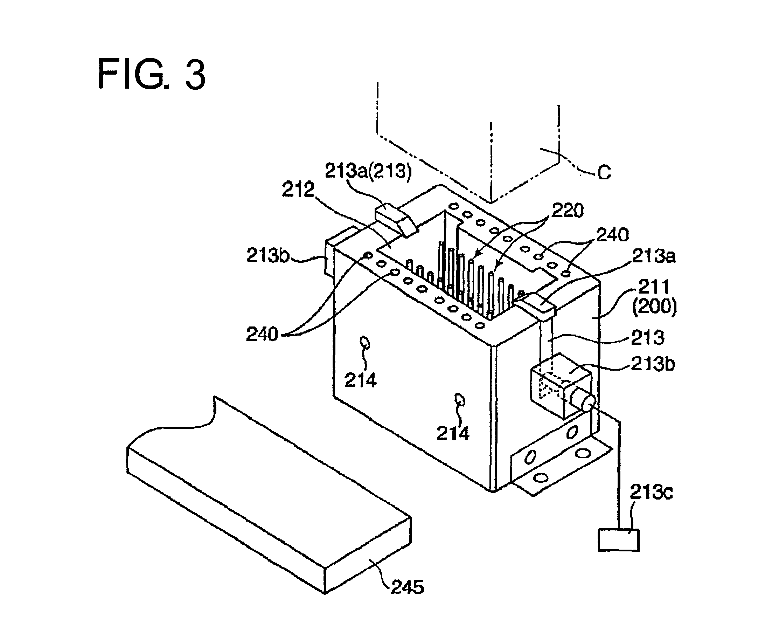

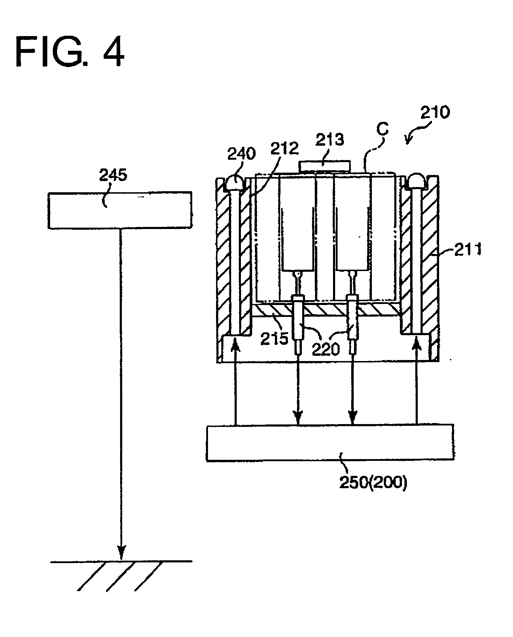

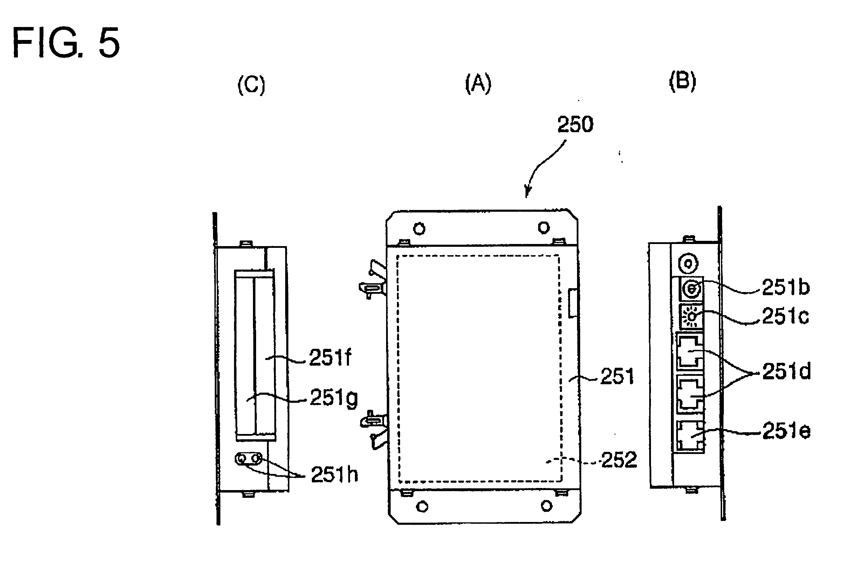

FIG. 3 is a perspective view enlargedly showing an essential portion of the terminal insertion assisting unit 200; FIG. 4A is a schematic section enlargedly showing the essential portion of the terminal insertion assisting unit 200; FIG. 4B is a schematic section through a preferred probe 220 to be used in the terminal insertion assisting unit 200; and FIGS. 5(A), 5(B) and 5(C) are a front view, a right side view and a left side view showing the external construction of the connector unit 250.

With reference to these FIGURES 3 to 5, each connector holder 211 is so formed as to have a substantially rectangular parallelepipedic outer shape and includes a substantially bottomed connector accommodating portion 212 having an opening in its upper surface in conformity with the outer shape of a connector C to be at least partly accommodated (shown only in phantom line in FIGS. 3 and 4). As shown in FIG. 2, the connector holders 211 take various shapes in conformity with the number of contacts and the shapes of the connectors C to be held. A plurality of these connector holders 211 are arranged to at least partly accommodate the corresponding connectors C in the connector accommodating portions 212 of the respective connector holders 211 and to, after one end of the terminal-provided wire W is connected with or at least partly inserted into the connector C at least partly mounted in one connector holder 211, connect the other hand thereof with the connector C mounted in another connector holder 211. Further, in the shown example, a pair of locks 213 are so mounted on the sides of the connector holder 211 as to be rotatable or pivotable about pins 214, and the connector C is prevented from coming out upward by resiliently engaging locking claws 213a with the upper surface of the connector C by unillustrated resilient members. In the shown embodiment, air cylinders 213b for driving the respective locks 213 in unlocking direction are provided on the sides of the connector holder 211. These air cylinders 213b are driven by starting and ending the supply of pressurized air from an unillustrated pressurized air supplying device by means of solenoids or solenoid valves 213c, which can be controlled by the connector units 250 and the master unit 260 to be described later.

Further, in the shown example, the respective connector holders 211 are arranged in an order corresponding to an arrangement order at the unillustrated main line. Thus, the subassembly formed at the connecting process can be efficiently conveyed to the main line by keeping its form maintained.

With reference to FIGS. 4A and 4B, a probe holding plate 215 is fixed at the bottom of the connector accommodating portion 212 of each connector holder 211. By this probe holding plate 215, a placing surface for receiving the bottom of the connector C accommodated in the connector accommodating portion 212 is formed and the probes 220 are held. The probes 220 are preferably provided in one-to-one correspondence with the contacts (terminal cavities) of the connector C held in each connector holder 211. While the connector C is being accommodated into the connector accommodating portion 212, the respective probes 220 enter the terminal cavities of the connector C and are connected with the terminal-provided wires W by mounting the ends of the terminal-provided wires W into the respective terminal cavities. The probes 220 are preferably formed such as described in the European patent application EP 00 114 021.0, which is incorporated herein by reference.

Next, with reference to FIGS. 3 and 4A, the connector holder 211 is provided with a plurality of guide lamps 240 corresponding to or indicating or instructing the contacts of the connector C to be accommodated.

The respective guide lamps 240 are preferably realized by light-emitting diodes (LED), and are one example of the connector-side connection instructing means to be connected with the master unit 260 via the connector units 250 to be described later. The guide lamps 240 may be alternatively provided as a display, such as a liquid crystal display (LCD). In the shown embodiment, a touch plate 245 as a grounding member electrically connected with a ground is mounted on the assembling board 100.

Next, with reference to FIGS. 1 and 2, the assembling board unit 30 is provided with temporarily holding jigs 290 for temporarily holding the terminal-provided wires W having so-called "free terminals" in the shown embodiment, i.e. terminals not to be inserted into a connector C at the present stage or processing step. The temporarily holding jigs 290 are realized by commercially available resilient clamps, and a plurality of temporarily holding jigs 290 are or may be so provided as to conform to the form of a wire assembly to be formed. The assembling board 100 is further provided with guide lamps or indicators 291 as end designating means provided near the temporarily holding jigs 290. These guide lamps 291 are also controlled by the master unit 260 by being connected therewith via the connector units 250.

FIGS. 5(A), 5(B) and 5(C) are a front view, a right side view and a left side view showing the external construction of the connector unit 250.

With reference to FIGS. 5(A) to 5(C), the shown connector unit 250 forms a connector-side node unit in this embodiment, and includes a casing 251 fixed to the rear surface of the assembling board 100 and a base plate 252 accommodated in or on this casing 251.

The base plate 252 is provided with a self node address setting switch 251 b, a sending-end node address setting switch 251c, a modular jack 251d for communication, a modular jack 251 e for solenoid or solenoid valves for driving the solenoids or solenoid valves 213c for the air cylinders 213b, a probe-connector connecting portion 251f with which socket connectors (not shown) of a plurality of probes 220 are or can be connected, and an indicator- or lamp-connector connecting portion 251g with which socket connectors (not shown) of the guide lamps 240 are or can be connected, the connecting portions 251f, 251g being provided on the left side surface of the casing 251. In the shown example, the socket connectors of the guide lamps 291 can be connected with the lamp-connector connecting portion 251 g by letting the guide lamps 291 of the temporarily holding jigs 290 and the socket connectors (not shown) provided in these guide lamps 291 have the same specifications as the guide lamps 240 of the connectors 211 and the socket connectors connected with the guide lamps 240.

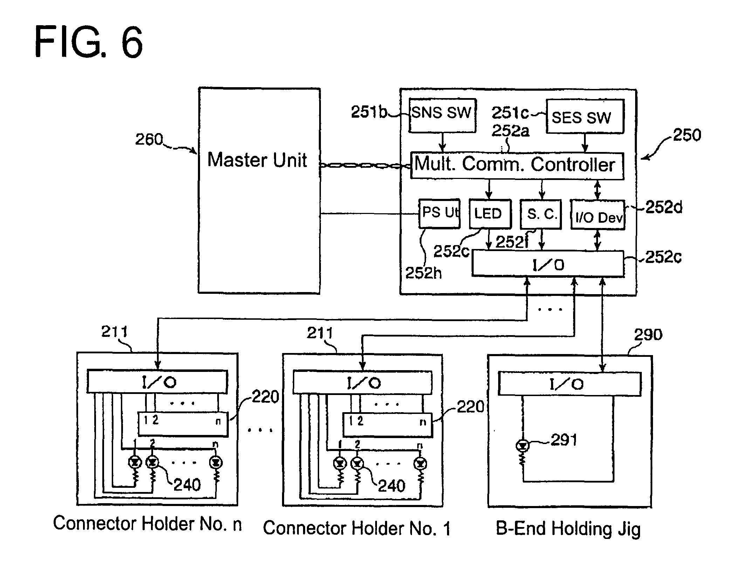

FIG. 6 is a block diagram of the connector unit 250 and the respective elements connected with the connector unit 250 according to the embodiment of FIG. 1.

With reference to FIG. 6, the base plate 252 of the connector unit 250 includes a multiplexing communication controller 252a connected or connectable with the address setting switches 251b, 251c, an I/O port 252c, an input/output device 252d, a LED controller 252e, and a solenoid driver or solenoid valve driver 252f.

The multiplexing communication controller 252a sets self node addresses and sending-end node addresses by means of the self node address setting switch 251b and the sending-end node address setting switch 251c, and conducts a time-division multiplexing communication between the connector unit 250 and the master unit 260 to be described later by a communication line connected with the modular jack 251d for communication.

The I/O port 252c is an interface with the probes 220 connected or connectble with the probe-connector connecting portion 251f and the lamp-connector connecting portion 251g, and the guide lamps 240, 291.

The input/output device 252d is connected with the probes 220 via the I/O port 252c and can discriminate the individual probes 220 by inputting signals to the probes 220 and sending outputs from the probes 220 to the master unit 260.

The LED controller 252e is or can be connected with the guide lamps 240 and/or the guide lamps 291 via the I/O port 252c, and can selectively turn on or off or blink the guide lamps 240, 291 in accordance with a control of the master unit 260.

The solenoid driver 252f is a unit including the modular jack 251e for solenoid, and can drive the unillustrated solenoids or solenoid valves based on an output from the master unit 260 to drive the locks 213 of the connector holder 211 by means of the air cylinders 213b.

A power supply unit 252h causes the respective elements to operate upon receiving a power supply from the master unit 260.

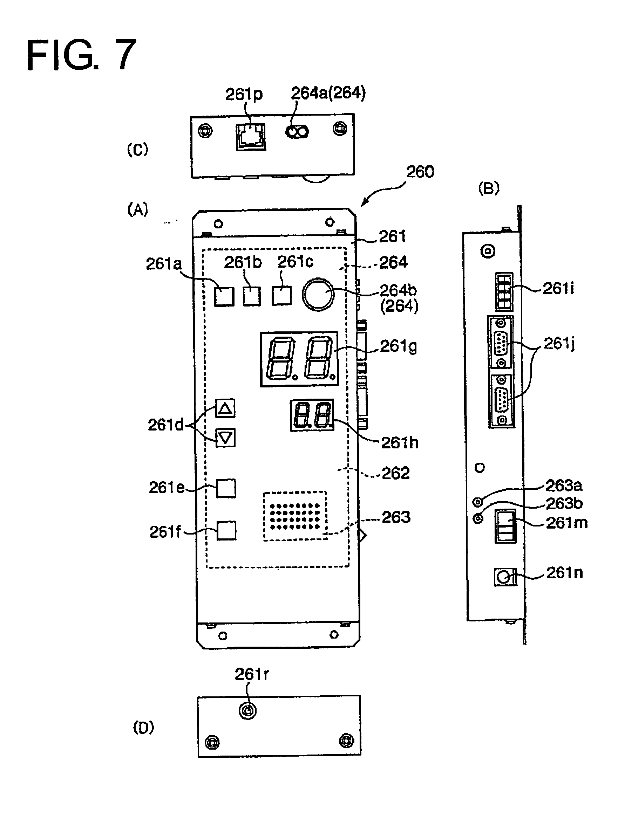

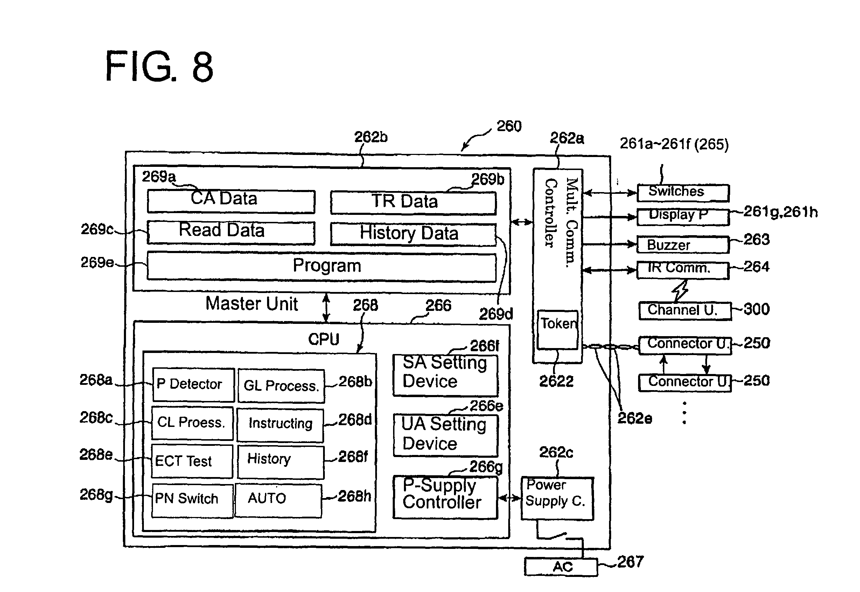

FIGS. 7(A) to 7(D) are a front view, a right side view, a plan view and a bottom view showing the external construction of the master unit 260, and FIG. 8 is a block diagram showing a connected state of the master unit 260 with the connector units 250 and the channel unit 300.

With reference to FIGS. 7(A) to 7(D), the master unit 260 is provided with a vertically long casing 261. A controller 262 is built in the casing 261. A buzzer 263 and an infrared communication unit 264 are provided in the controller 262, and these electronic parts are accommodated in the casing 261.

The controller 262 is provided with setting switches 261 a to 261 f provided on the front surface of the casing 261, and a product-number display panel 261 g, and a station-number display panel 261h. Further, the controller 262 is or can be connected with a dip switch 261 i provided at the right side of the casing 261, an optional unit connection port 261j, a power switch 261m, and an AC adapter connection port 261 n. The controller 262 is or can be also connected with a modular jack 261 p provided on top of the casing 261 and can be so connected as to enable a multiplexing communication with the respective connector units 250 via the modular jack 261p (see FIG. 8). The controller 262 is provided with a check-switch connecting portion 261 r provided at the bottom of the casing 261, and can implement a specified program based on outputs from operation switches (shown only in FIG. 8) connected with the check-switch connecting portion 261 r.

On the other hand, the infrared communication unit 264 includes a communication port 264a provided on top of the casing 261.

With reference to FIG. 8, the controller 262 is provided with a multiplexing communication controller 262a, a storage 262b and a power-supply control circuit 262c. These devices 262a to 262c are connected with a CPU 266 for controlling the operations of the controller 262 as well as with the setting switches 261a to 261f, the display panels 261 g, 261 h, the buzzer 263 and the infrared communication unit 264.

The multiplexing communication controller 262a is connected with the multiplexing communication controller 252a of one connector unit 250 via twisted pair cables 262e connected with the modular jack 261p shown in FIG. 7(C). The master unit 260 builds a local area network (LAN) as a master node connected with a busshaped multiplexing communication path while using the respective connector units 250 as slave nodes by connecting the multiplexing communication controllers 252a of the respective connector units 250 by the unillustrated twisted pair cables.

Each multiplexing communication controller 262a of this embodiment includes a token issuing circuit 2622 for issuing tokens to the respective controller units 250 as slave nodes, and is connected with the respective switches 261a to 261f, 265, the display panels 261 g, 261 h, the buzzer 263 and the infrared communication unit 264.

With reference to FIG. 8, the storage 262b is preferably realized by a ROM and a RAM, and includes a connection assisting data storage section 269a for storing connection assisting data used to assist the connection, a test standard data storage section 269b for storing test standard data used for an electrical connection test, a read data storage section 269c for storing a connection information of a network formed by the terminal-provided wires W to be tested as a read data, a history data storage section 269d for storing a history information as a history data, and a program storage section 269e for storing a program for controlling the master unit 260.

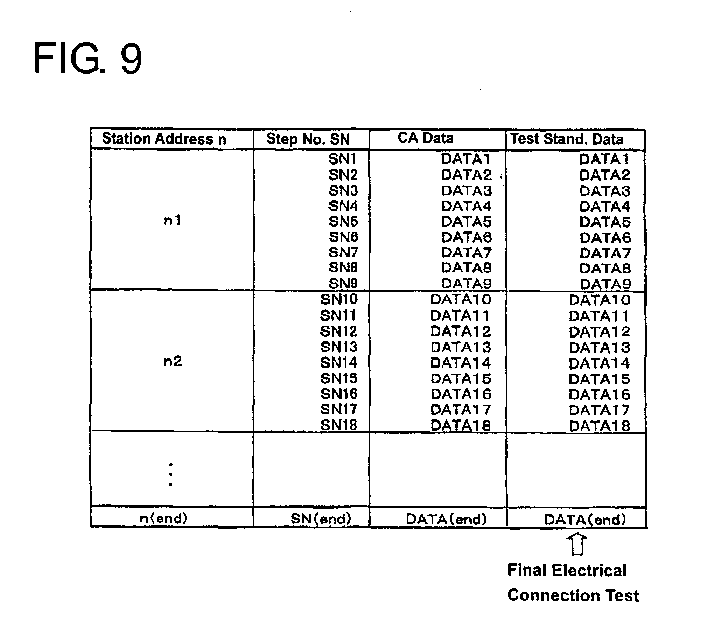

FIG. 9 is a data table showing data used in this embodiment in a list format.

As shown in FIG. 9, the connection assisting data and the test standard data are both classified for the respective station addresses "n" of the stations ST, and data at the respective station addresses are registered in the order of step numbers SN performed to connect the terminal-provided wires. Thus, in a connection assisting operation to be described later, the connection can be cumulatively assisted from a first connecting operation to a final connecting operation and the electrical connection test can be conducted in a plurality of stations ST.

In the shown embodiment, the connection assisting data storage section 269a and the test standard data storage section 269b store data corresponding to a plurality of product numbers, so that an operation data corresponding to the product number selected based on the processing of a product number switching device 268g and an automatic processing device 268h to be described later can be developed.

An operation of teaching the respective data in the shown example is performed by operating the setting switches 261a to 261f similar to a general control unit. Alternatively, the respective data can be downloaded from a computer 400 to be described later.

The power supply control circuit 262c controls a power supply from an AC adapter 267 (shown only in FIG. 1) connected with the AC adapter connection port 261 n. In the shown example, the power switch 261 m shown in FIG. 7(B) is inserted between the power supply control circuit 262c and the AC adapter 267. The AC adapter 267 is slidably or movably electrically connected with the power supply line 61 (see FIG. 1) provided in the subassembly line SL as shown in FIG. 1, and is constructed to supply a power from the power supply line 61.

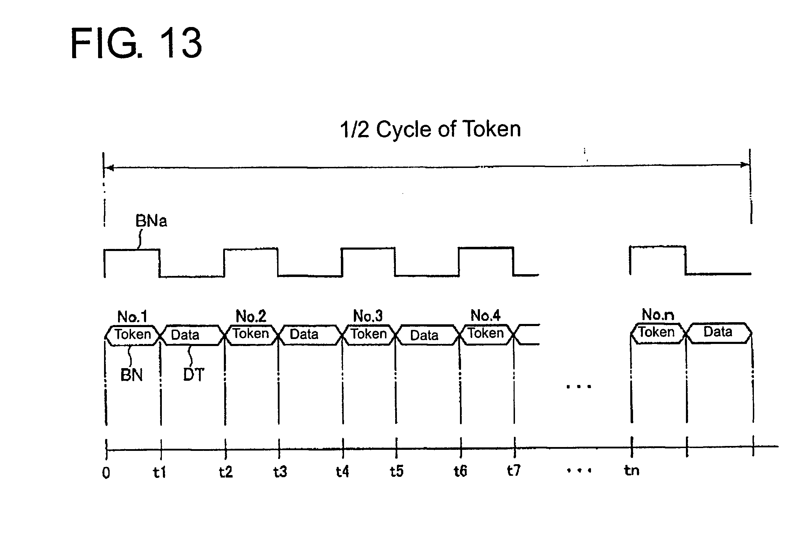

The infrared communication unit 264 is capable of conducting a multiplexing communication with an infrared communication unit 304 of the channel unit 300 to be described later via the communication port 264a (see FIG. 7(C)). When the infrared communication unit 264 is communicating with a communication port 304a (see FIG. 13(E)) of the infrared communication unit 304 of the channel unit 300, a display lamp 264b shown in FIG. 7(A) is turned on to display such a state.

The CPU 266 includes a unit address discriminator 266e for recognizing the respective connector units 250, a station address discriminator 266f for discriminating the station addresses "n" of the channel units 300 to be described later, a power supply controller 266g for controlling the power supply control circuit 262c, and a connection assisting device 268 for controlling signals from the probes 220 (see FIGS. 2 to 6) of the connector holders 211.

The unit address discriminator 266e contributes to an operation of specifying the probes 220 and the guide lamps 240 handled by the connection assisting device 268 by specifying the addresses of the connector units 250.

The station address discriminator 266f specifies the station address "n" of the station ST where the wire supply table 40 is installed based on a value set in a station address setting portion for the channel unit 300 installed at each station ST, thereby contributing to the control of the connection assisting device 268.

The connection assisting device 268 includes a probe detector 268a for detecting a voltage of the probe 220 corresponding to the terminal-provided wire W to be instructed; a guide lamp processor 268b for controlling the guide lamps 240 of the connector holders 211 or the guide lamps 291 of the temporarily holding jigs 290; a channel lamp processor 268c for controlling the guide lamps of the wire supply table 40 to be described later; an instruction or teach-in processor 268d for controlling the guiding of the terminal-provided wires W; an electrical connection testing device 268e for governing or administering the electrical connection test for the connected terminal-provided wire W; a history processor 268f for processing a history information of the electrical connection test; the product number switching device 268g for switching the product numbers to be processed by the respective processors 268a to 268f; and the automatic processing device 268h for automatically performing the switching operation by the product number switching device 268g.

The probe detector 268a detects the voltage of the probe 220 corresponding to the terminal-provided wire W to be instructed. Although not specifically shown, a circuit through which a detection current flows preferably via a pullup resistor is formed in each probe 220. If an other rod 223 of the probe 220 is disconnected from the ground, the voltage level of this other rod 223 rises and such a shift can be detected by a voltage difference.

The guide lamp processor 268b can selectively turn on or blink the guide lamps 240, 291 (or switch a corresponding display) corresponding to the terminal-provided wire W to be instructed.

The channel lamp processor 268c is connected with the guide lamps 320 of the wire supply table 40 and can selectively turn on the guide lamp 320 corresponding to the terminal-provided wire W to be instructed.

The instruction processor 268d governs a later-described connection instructing operation of instructing one end (hereinafter, "A-end") and the other end (hereinafter, "B-end") of the terminal-provided wire W to be selected from the wire supply table 40.

The electrical connection testing device 268e has a function of checking whether or not the A-end and B-end of the terminal-provided wire W are properly connected based on the test standard data registered in the storage 262b beforehand every time the A-end and B-end are connected, and can conduct an electrical connection test for all the circuits when all the terminal-provided wires W corresponding to each station ST are connected.

The history processor 268f stores the electrical connection tests conducted by the electrical connection testing device 268e and the operations performed by the respective lamp processors 268b, 268c to turn on and off and blink the guide lamps 240, 291, 320 as a history information in the history data storage section 269d of the storage 262b. The history information is used to turn on the guide lamp 240 corresponding to an unfinished operation when the operator operates the operation switch 265. This function is suitably used, for example, in the case that the operator does not know where to start the operation after interrupting it.

The product number switching device 268g specifies the product number of the subassembly to be formed for each assembling board 100 on which the master unit 260 is provided. By providing the product number switching device 268g, the product numbers of the subassemblies can be administered for each of the assembling boards.

The automatic processing device 268h automatically sets the product switching operation by the product number switching device 268g. Specifically, in the case that the address "n" of the station ST is changed based on an output from the station address setting portion 306 of the channel unit 300 to be described later, the product number switching operation is automatically changed in accordance with a changed value.

Next, the channel unit 300 provided in the wire supply table 40 is described.

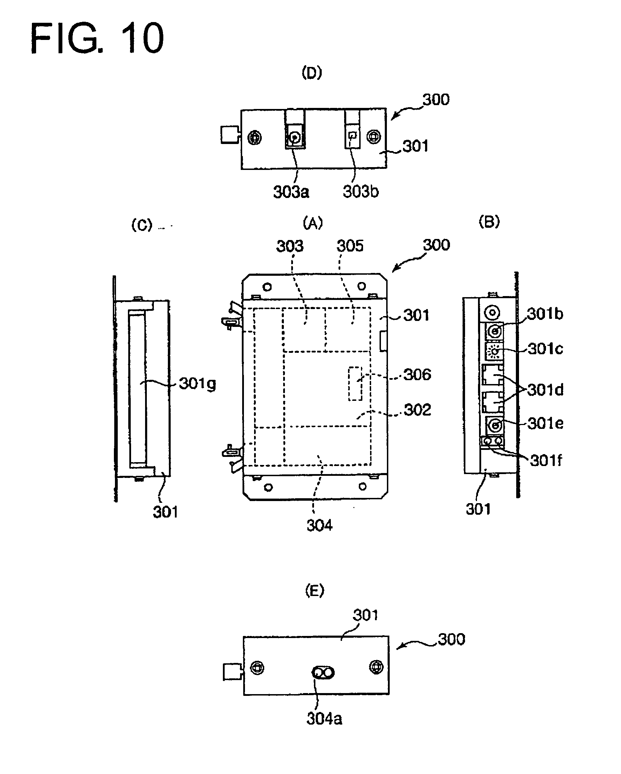

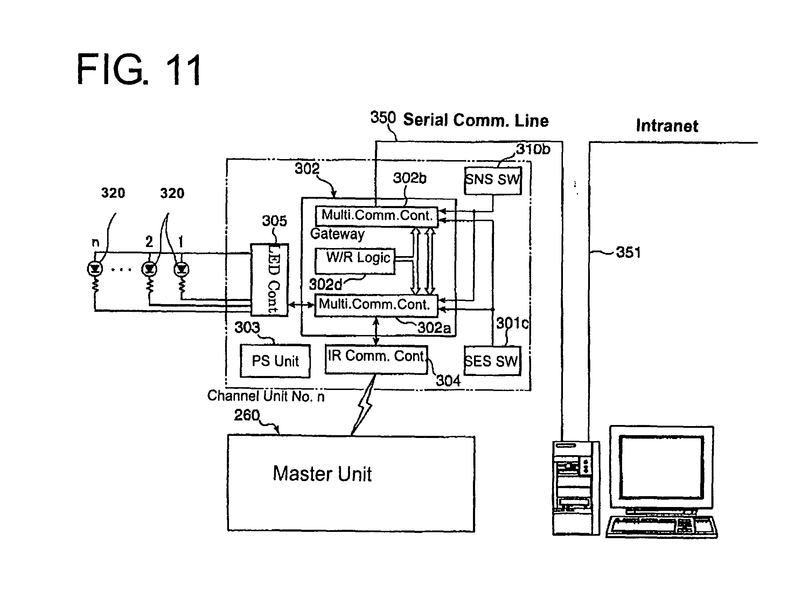

FIGS. 10(A), 10(B), 10(C), 10(D) and 10(E) are a front view, a right side view, a left side view, a plane view and a bottom view showing the external construction of the channel unit 300, and FIG. 11 is a block diagram showing a wired state of the channel unit 300.

With reference to FIGS. 10(A) to 10(E), the shown channel unit 300 forms the wire-side node unit in this embodiment and is provided with a casing 301. The casing 301 is internally provided with a gateway unit 302, a power supply unit 303, the infrared communication unit 304 and a LED controller 305.

The gateway unit 302 includes a pair of multiplexing communication controllers 302a, 302b corresponding to a pair of modular jacks 301d for communication and connected with both a self node address setting switch 301b and a sending-end node address setting switch 301c provided on the right side surface of the casing 301, and a W/R control logic circuit 302d for controllably switching the respective multiplexing communication controllers 302a, 302b. Further, the gateway unit 302 is connected with a rotary switch 301 e for system control via an unillustrated I/O unit, a LED 301f for action display, and a lamp-connector connecting portion 301g provided on the left side surface of the casing 301 and connected with socket connectors (not shown) of a plurality of guide lamps 320.

The pair of multiplexing communication controllers 302a, 302b and the W/R control logic circuit 302d form a gateway for connecting a communication network built between the channel unit 300 and the master unit 260 and an other network (e.g. Intranet) or bi-/multidirectional communication system built in a factory.

One multiplexing communication controller 302a is so connected as to enable a multiplexing communication with the master unit 260 via the infrared communication unit 304, and can send an instruction signal to the LED controller 305 in response to an instruction from the master unit 260, thereby selectively turning on the guide lamps 320 as the wire-side connection assisting means.

The other multiplexing communication controller 302b is connected with the computer 400 for monitoring via a serial communication cable 350 and is connected with an Intranet or bi-/mutidirectional communication system 351 built in the factory via the computer 400.

The power supply unit 303 includes an AC adapter connection port 303a provided on the upper surface of the casing 301 and controls a power supply from an AC adapter 330 (shown only in FIG. 1) connected with this AC adapter connection port 303a. In the shown example, the power supply unit 303 is provided with a power switch 303b shown in FIG. 10(D). The AC adapter 330 is electrically connected with the power supply line 62 (see FIG. 1) provided in the subassembly line SL as shown in FIG. 1 to supply a power from this power supply line 62.

The infrared communication unit 304 is a unit capable of conducting a bilateral or bidirectional communication with the infrared communication unit 264 of the master unit 260 and includes the communication port 304a provided on the bottom surface of the casing 301. The gateway unit 302 can control the LED controller 305 in accordance with a signal from the master unit 260 received by the infrared communication unit 304 through the communication port 304a, thereby selectively turning on the guide lamps 320 controlled by the LED controller 305.

In the embodiment of FIG. 11, the infrared communication unit 304 provided in each channel unit 300 is connected with the computer 400 via the serial communication cable 350, and can monitor a state of communication between the master unit 260 and the channel unit 300. Thus, in the shown embodiment, a connecting operation information in each master unit 260 can be monitored as a production administration information, and various operations can be administered.

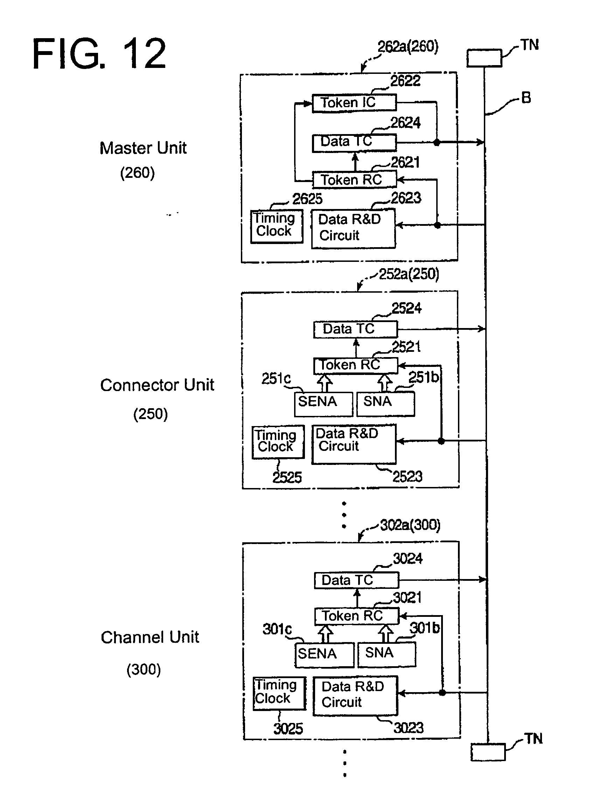

Next, with reference to FIGS. 12 and 13, the multiplexing communication controllers 252a, 262a, 302a provided in the respective units 250, 260, 300 are described in detail with reference to FIG. 12.

FIG. 12 is a block diagram showing the multiplexing communication controllers 252a, 262a, 302 of the respective units 250, 260, 300 in detail.

With reference to FIG. 12, the multiplexing communication controllers 252a, 262a, 302a of the respective units 250, 260, 300 include token receiving circuits 2521, 2621, 3021 for receiving the tokens from a bus B forming the LAN; data receiving and deciphering circuits 2523, 2623, 3023 for receiving and deciphering data from the bus B; data transmitting circuits 2524, 2624, 3024 for transmitting the data upon the receipt of output signals of the data receiving and deciphering circuits 2523, 2623, 3023; and timing clocks 2525, 2625, 3025. In FIG. 12, the bus B forms a busshaped network, and a network terminal TN is provided at its terminus end.

Here, the self node addresses and the sending-end node addresses set by the respective address setting portions 266f, 266e (see FIG. 8) of the CPU 266 are inputted to the token receiving circuits 2521 of the master unit 260, whereby the node addresses of all the units 250, 260, 300 and the tokens can be related to each other.

On the other hand, the token receiving circuits 2521, 3021 of the respective units 250, 300 excluding that of the master unit 260 are connected with the self node address setting switches 251b,301b and the sending-end node address setting switches 251c, 301c, and the node addresses of all the units 250, 260, 300 and the tokens can be related to each other by these setting switches 251b,301b, 251c, 301 c.

The multiplexing communication controller 262a of the master unit 260 is provided with a token issuing circuit 2622 for issuing tokens upon the receipt of an output signal of the token receiving circuit 2621, so that the tokens can be given to the respective units 250, 300 by a method to be described later.

This token issuing circuit 2622 gives the tokens to all the units 250, 260, 300 at timings of output bit sets BN by outputting the timing bit sets at specified intervals as token signals.

FIG. 13 is a diagram showing a state of a perfect time-division multiplexing communication by the master unit 260 of this embodiment.

First, with reference to FIG. 13, a horizontal axis represents time, BNa and BN denote an issuing cycle of token signals issued by the token issuing circuit 2622 and a timing bit set issued as the token signal, respectively. In the shown example, an output is made by a frequency-modulation method adopting a broadband system.

In this embodiment, the token issuing circuit 2622 of the master unit 260 repeatedly issues the token signal in a cycle of a period between 0 and t2. This token issuing circuit 2622 issues the token signals as a timing marker during the front halves of the cycles 0 to t1, t2 to t3, t4 to t5, t6 to t7, etc., whereas the units 250, 260, 300 having the node addresses coinciding with those of the issued token signal output a data DT to the bus B during the rear halves of the cycles t1 to t2, t3 to t4, t5 to t6, etc. In this way, the master unit 250 can give the tokens to all the units including itself by successively repeating the issuance of the timing bit set BN by the number of the units.

Further, as shown in FIG. 12, the token receiving circuits 2521, 2621, 3021 and the data receiving and deciphering circuits 2523, 2623, 3023 provided in the respective units 250, 260, 300 monitor the common bus B to which the token signals BN and the data DT are outputted. Thus, the data DT outputted from any of these units can be shared. As a result, a single database built in the storage 262b of the master unit 260 can be shared by all the connector units 250 and channel units 300.

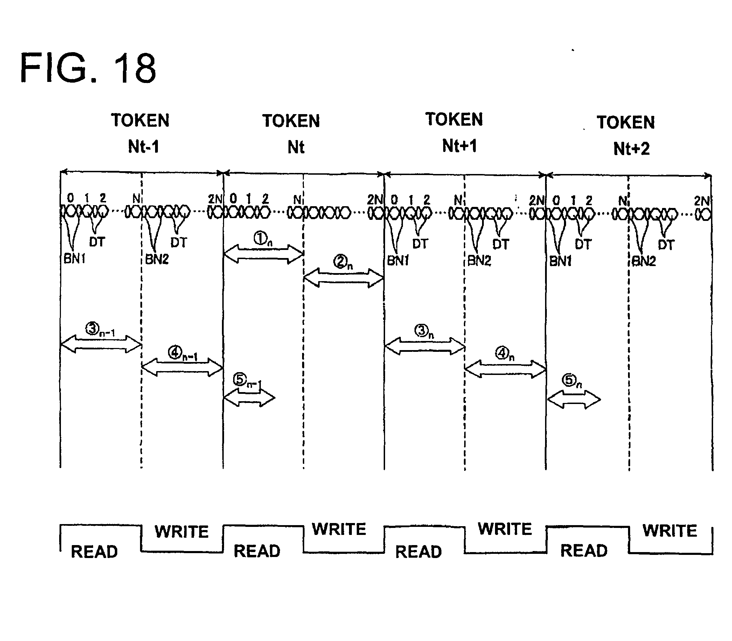

In order to shorten a waiting time which elapses after the issuance of the token signal BN until the data DT corresponding to this issued token signal is inputted to the master unit 260, the electrical connection test of this embodiment is programmed such that the token signal BN is issued 2N times within one cycle of the token upon conducting the communication with N connector units 250, and the data output is required in the first N issuing cycles while the data outputted from the connector units 250 are written in the RAM in the latter N issuance cycles (see FIG. 18 to be described later).

In this embodiment, a multiplexing communication control system adopting a perfect time-division multiplexing communication method is constructed by the multiplexing communication controllers 252a, 262a, 302a, the communication cables and the like.

Next, with reference to FIGS. 1, 14 to 17, a connecting process performed when the subassembly is formed is described.

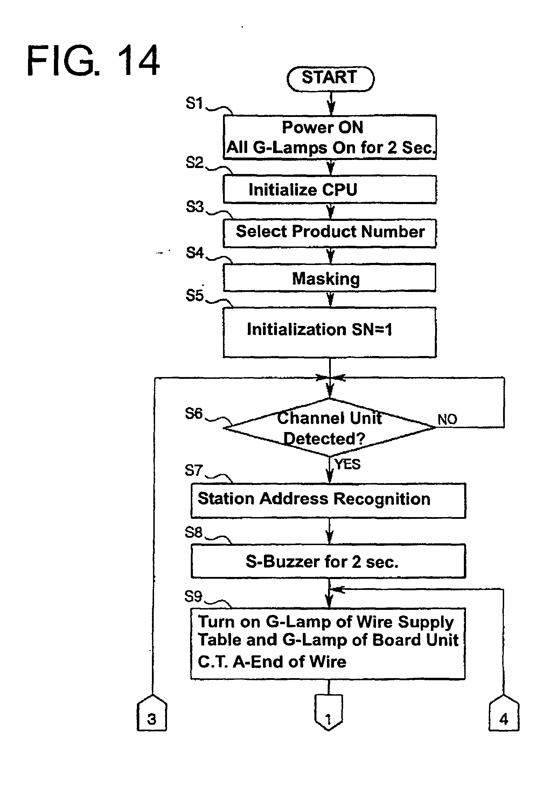

FIGS. 14 to 17 are flow charts showing the detail of the connecting process according to the present invention.

First, with reference to FIG. 1, the assembling board unit 30 is intermittently preferably hand-conveyed from one station ST located at upstream side to another located downstream side by the conveyor 20 in the subassembly line SL as described above, and the operation of connecting the terminal-provided wires W is performed at each station ST.

In this connecting operation, all the connectors C necessary to form the subassembly are at least partly mounted in the respective connector holders 211 arranged on the assembling board unit 30 beforehand, and the power switch 261m (see FIG. 7(B)) of the master unit 260 and the power switch 303b (see FIG. 10(C)) of the channel unit 300 are operated to turn these units 260, 300 on.

Upon being turned on, the master unit 260 turns all the guide lamps 240, 291 on for a specified (predetermined or predeterminable) period of time, e.g. for 2 sec. (Step S1) and initializes the CPU 266 (Step S2). In this way, the operator can check whether or not the respective lamps are in order and, if any, can confirm an abnormality of the guide lamps 240, 291 themselves before the connecting operation.

Next, the controller 262 of the master unit 260 develops the product number data selected by the product number switching device 268g based on the product number set by the setting switches 261a to 261f beforehand (Step S3). It is also possible that the product number is read or detected by a suitable reader or detector (not shown), e.g. a bar code reader.

Upon the development of this data, a instruction processor 268d of the master unit 260 performs masking (Step S4). In this masking, the wire instructing device 427 selects the probes 220 requiring no signal processing and excludes the probes 220 and the corresponding guide lamps 240 from the objects to be controlled, thereby preventing an erroneous operation.

Next, the controller 262 initializes a step number SN (see FIG. 9) used to administer the process of connecting the terminal-provided wires W (Step S5). In this way, the master unit 260 can specify the address "n" of the wire supply table 40 to be controlled and the step number SN.

Upon the completion of the respective operations in Steps S1 to S5 by the controller 262, the infrared communication unit 264 of the master unit 260 waits on standby until being connected with the infrared communication unit 304 of the channel unit 300 (Step S6). When the assembling board unit 30 arrives at the first station ST in this state, a communication is established between the infrared communication units 264, 304 of the master unit 260 and the channel unit 300. Thus, the CPU 266 recognizes the station address "n" set in the station address setting portion 306 of the channel unit 300 (Step S7). Subsequently, a success buzzer is driven for 2 sec. and the station address "n" is displayed on the station display panel 261 h (Step S8). Then, the instructing device 268d and the guide lamp controllers 268b, 268c are operated to turn on the guide lamp 320 of the wire supply table 40 corresponding to the first terminal-provided wire W and the guide lamp 240 of the connector holder 211 holding the connector to be connected with the A-end of this terminal-provided wire W (Step S9). In this way, the operator takes or is instructed to take the terminal-provided wire W out of the channel section 41 corresponding to the turned-on guide lamp 320 and connects the A-end thereof with the connector C in the connector holder 211 indicated by the guide lamp 240.

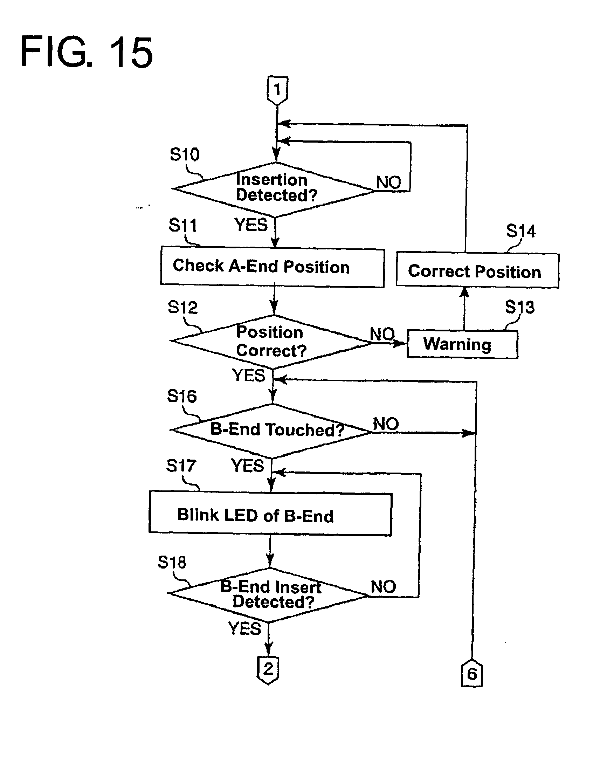

In Step S10 of FIG. 15, the CPU 266 waits until the A-end of the terminal-provided wire W is inserted after the guide lamps 240, 320 are turned on. This discrimination is made by detecting a voltage change in the corresponding probe 220. Specifically, when the terminal T of the terminal-provided wire W is inserted into the terminal cavity of the connector C, it pushes one rod 222 of the probe 220, thereby displacing the other rod 223 located below the rod 222 (refer to FIG. 4B). Thus, the other rod 223 is electrically disconnected from a sleeve 221 and, accordingly, disconnected from the ground. As a result, the connection of the A-end can be detected by detecting a voltage change of the other rod 223 increased by the detection current.

When the A-end is connected, the electrical connection testing device 268e of the CPU 266 checks whether or not the A-end of the terminal-provided wire W is connected with a proper contact at this time in Steps S11, S12 of FIG. 10. Unless the terminal-provided wire W is connected with the proper contact, a buzzer controller 266c of the CPU 266 drives the buzzer 263 to notify the operator of an erroneous connection (Step S13). In such a case, the insertion position is corrected (Step S14) and this routine returns to Step S10 again.

If the A-end is properly connected, Step S16 of FIG. 15 follows to wait until the operator brings the B-end of the terminal-provided wire W corresponding to the connected A-end into contact with the touch plate 245.

When the operator brings the B-end into contact with the touch plate 245, Step S17 of FIG. 15 follows, in which the voltage of the probe 220 corresponding to the A-end falls again. In this way, the connection assisting device 268 of the CPU 266 can specify the guide lamp 240 to be turned on. The guide lamp processor 268b in turn blinks the corresponding guide lamp 240 or guide lamp 291. Since the guide lamp 240 corresponding to the A-end and the guide lamp 240 corresponding to the B-end are simultaneously used in this embodiment, the guide lamp 240 is blinked to indicate the B-end so that the indications of the A-end and B-end can be distinguished from each other. During the process of instructing the connection of the B-end, the guide lamp 240 corresponding to the A-end is kept turned on. Then, in Step S18, it is waited until the terminal T at the B-end is connected or inserted into the respective connector C.

Upon seeing the guide lamp 240 turned on, the operator inserts the terminal T at the B-end into the corresponding terminal cavity of the connector C. Then, similar to the case of the A-end, an output voltage of the probe 220 corresponding to the terminal T at the B-end changes. Thus, the CPU 266 can discriminate (Step S18) the connection of the terminal T at the B-end and its position of connection (contact).

In the case that the terminal T brought into contact with the touch plate 245 is a so-called later-inserted terminal, the instructing device 268d turns the guide lamp 291 of the corresponding temporarily holding jig 290 on only while the terminal T is held in contact with the touch plate 245.

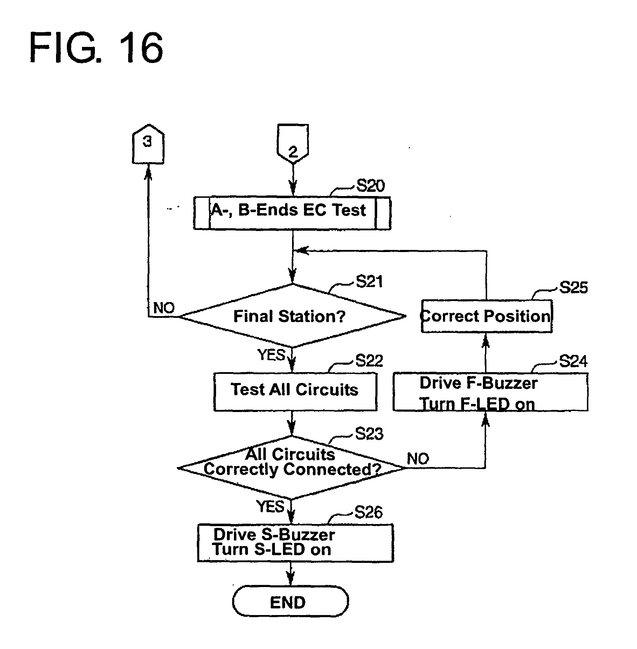

When the terminal T at the B-end is connected, the electrical connection testing device 268e of the CPU 266 conducts the electrical connection test for the connected terminal-provided wire W in Step S20 of FIG. 16. Upon the completion of this electrical connection test, the CPU 266 judges whether or not the station ST where the connecting process is being performed is the last station. In the case of the last station ST, Step S22 follows, in which the electrical connection test is conducted for all the circuits of the wiring harness laid on the assembling board 100.

In this electrical connection testing step (Step S22), the CPU 266 controls a input/output device 252d, causes the output voltages of the respective probes 220 corresponding to the A-ends to fall one by one to a ground level while checking the output voltages of the respective probes 220 corresponding to the B-ends, thereby testing the connected states of the circuits (Step S23). If an erroneous connection is detected, the buzzer 263 is driven and the corresponding guide lamp 240 is blinked to notify an error (Step S24), and the operator corrects or can correct this error accordingly (Step S25).

On the other hand, in the case of passing the electrical connection test, Step S26 follows, in which the buzzer 263 is driven to notify a success. The success and failure notifications by the buzzer 263 may be made distinguishable one from the other by setting a long buzzing sound for the one while setting a short buzzing sound for the other, by setting different frequencies for the respective sounds, or the like.

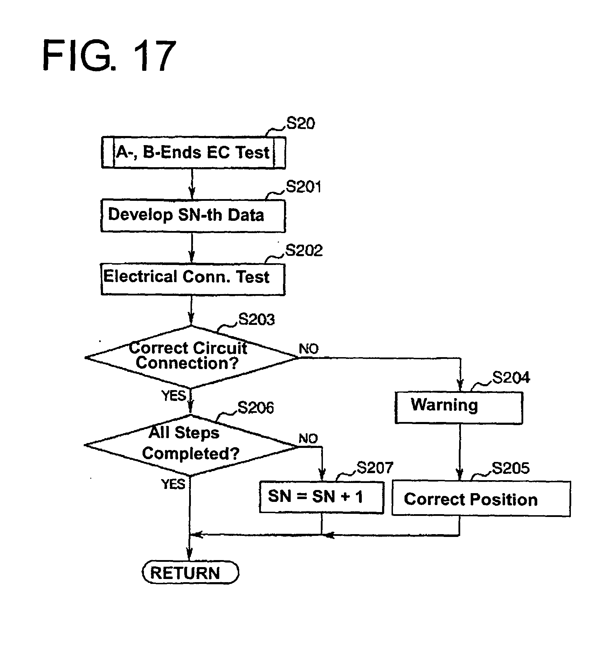

FIG. 17 is a flow chart showing the detail of Step S20 of FIG. 16.

With reference to FIG. 17, in the electrical connection test (Step S20) according to the shown embodiment, the test standard data (see FIG. 9) of the step number SN to be handled is developed in Step S201. Subsequently, in Step S202, the electrical connection test is conducted based on the developed test standard data stored in the test standard data storage section 269b.

If the connected state of the terminal-provided wire W is different from a proper connected state stored in the storage 262b beforehand, the CPU 266 judges a failure in the connection of the B-end and an error notification is made by means of the buzzer 263 (Step S204). Accordingly, the operator corrects or can correct the connection of the B-end (Step S205).

On the other hand, upon judging that the connection of the B-end is as specified, the CPU 266 turns off the guide lamps 240 corresponding to the connected terminal-provided wire W and discriminates whether or not all the connecting operations at the station ST have been completed in Step S206 of FIG. 17. Upon the completion of the connection of all the terminal-provided wires W, this subroutine immediately returns to the flow of FIG. 16. On the other hand, if there still remains any terminal-provided wire W to be connected, this subroutine returns to the flow of FIG. 16 after the step number SN is renewed in Step S207. The procedure described above is repeated. In the shown embodiment, the electrical connection test is conducted in Step S20 every time the B-end of the terminal-provided wire W is connected. The electrical connection test information of the network built by the terminal-provided wire W is stored as the test standard data in the test standard data storage section 262b, preferably for each terminal-provided wire W up to the final stage, and the CPU 266 as a discriminating means develops the test standard data cumulatively stored in Step S201 and conducts the electrical connection test (Step S20) based on the developed test standard data. Thus, whether or not the network is proper is discriminated by this electrical connection test every time the terminal-provided wire W is connected in the production process of the wiring harness being tested.

Next, a data processing procedure in the case of conducting the electrical connection test in the aforementioned connection assisting process is described with reference to FIG. 18. FIG. 18 is a timing chart showing a specific example of signal processing in the case that the multiplexing communication method of this embodiment is applied to the electrical connection test.

In the shown embodiment, the same number of bit sets BN1 as the number N of all the connector units 250 connected with the bus B are outputted in the first half of one cycle of the token, thereby letting the respective connector units 250 receive the tokens, whereas the same number of bit sets BN2 are outputted in the second half of one cycle of the token, thereby sending data packets to the slave nodes required to output the data.

As shown in FIG. 18, one electrical connection test is conducted during a period of 2.5 cycles of the token (e.g. Nt to Nt+2).

During this period, N (e.g. 64) bit sets BN1 are outputted from the master unit 260 since a test signal used to conduct the electrical connection test is outputted in the first half ①n of the token cycle Nt based on the read data of the network decided in preceding cycle Nt-1.

Subsequently, the bit sets BN2 for sending out the data packets are sent in the second half ②n of this cycle Nt, whereby the read data of the network outputted from the probes 220 of the connector holders 211 are written in the read data storage sections 269c of the connector units 250. However, the data at this time is ignored in order to take into account a time jitter possibly caused by a stray capacity of the wiring network. The readout is preferably performed at a readout time delayed by a specified time with respect to the input signal which is greater than the possible time jitter caused by the stray capacity. Accordingly, it is preferably possible to guarantee a response time of the system in contrast to a CSMA/CD protocol according to

### prior art.

Since the read data are canceled in the second half ②n, the read data of the network decided in the section On are maintained when the bit sets BN1 are outputted from the master unit 260 to the connector units 250 in first half ③n of a next cycle Nt+1.

Subsequently, the bit sets BN2 for sending out the data packet are sent in the second half ④n of the cycle Nt+1, whereby the read data of the network are written in the read data storage section 269c of the master unit 260. The electrical connection testing device 268e compares the read data with the corresponding test standard data to discriminate a success or a failure during an interval On. In parallel, the bit sets BN1 are outputted in the first half of a cycle Nt+2 of the token, and the read data are decided for a next electrical connection test during this interval.

In the case that an error in picking up the signals occurs in the electrical connection test (Step S20) during the interval ⑤n, the test is conducted again retroactively to the interval ④n-1 of the cycle Nt-1.

As described above, according to this embodiment, the perfect time-division multiplexing communication method for transmitting and receiving the data while causing the timings of the token signals BN and the node addresses to coincide by outputting the token signals BN at the specified intervals is adopted upon assisting the wire connecting operation by causing the guide lamps 240, 291 provided on the assembling board 100 and the guide lamps 320 provided for each of the plurality of stations ST to cooperate. Thus, it is not necessary to establish the communication conditions between the master unit 260, the connector units 250 and the channel units 300 as the nodes for transmitting and receiving the data, and the data can be transmitted and received without a protocol. This remarkably shortens the response time between the master unit 260, the connector units 250 and the channel units 300 for transmitting and receiving the data. Thus, even if the wires are instructed to the guide lamps 240, 291, 320 in a complicated manner, these guide lamps 240, 291, 320 can be quickly controlled at a practical speed. Since this enables a unitary administration of the connection assisting information and the electrical connection test information of the large-size wiring harness by the master unit 260 using the single database, the data can be more easily administered and renewed. Further, since the protocol-free communication mode is adopted, it is not necessary to develop a software for establishing a protocol between the master unit 260, the connector units 250 and the channel units 300, which contributes to a cost reduction.

Even if the number of the circuits of the wiring harness is relatively large, the connector holders 211 connected with the connector units 250 can be arranged within an area where wiring is considerably simplified. As a result, the electrical connection tests, the connection assistance or the multiplexing communication with electronic devices connected with the wiring harness can be performed while a wiring harness having a large number of circuits (e.g. 200 to 300 circuits) can be placed on the assembling board 100 having such an area that the wiring harness cannot be physically placed in the prior art.

Further, by adopting the perfect time-division multiplexing communication method, the master unit 260 needs not establish the communication conditions with the connector units 250 and the channel units 300. This eliminates the need for providing the connector units 250 and the channel units 300 with microprocessors, with the result that a simple and inexpensive hardware construction can be adopted.

Furthermore, by conducting the multiplexing communication between the master unit 260, the connector units 250 and the channel units 300, wiring between the respective units 250, 260, 300 can be simplified, and the electrical connection tests and the connection assistance can be performed on the compact assembling board 100 even if the wiring harness has a relatively large number of circuits (e.g. having 960 contacts).

Further, by adopting the perfect time-division multiplexing communication method, the multiplexing communications between the respective units 250, 260, 300 are enabled only by setting the timing bit sets BN outputted at the specified intervals and the node addresses. Thus, the connector units 250 and the channel units 300 can be easily increased and decreased, and a change in the hardware specification of the wiring harness can be easily dealt with.

Particularly, the master unit 260 of this embodiment has the function of testing the electrical connection of the network including the connected terminal-provided wire W every time the terminal-provided wire W as a harness-forming wire is connected with the connector C held in the connector holder 211, and causes the respective connection instructing means to carry out the next connection assistance only in the case of a success in the electrical connection test. Thus, an error connection can be detected by a real-time response, thereby preventing a defective product from being conveyed to a later step. Further, by adopting the perfect time-division multiplexing communication method, a time required for the electrical connection test can be remarkably shortened. Thus, a processing time between one set of the connecting operation and the electrical connection testing operation and the next set can be shortened, with the result that the operator needs not spend a waiting time.

The wire supply table 40 of this embodiment is installed at each of the plurality of stations ST installed along a conveyance path for the assembling boards 100, and the master unit 260 is so constructed as to test the electrical connection up to the final stage of the production process of the wiring harness being tested. Thus, the instruction of the wire connection and the electrical connection test can be seamlessly carried out from the first station ST to the last station ST. Therefore, even if the operator is changed between the respective stations ST or the operation is interrupted, there is no variation in the quality of the connecting operations.

Further, in this embodiment, the tokens are given by the perfect time-division method according to which the same number of the bit sets BN1 for the reading of the tokens and the bit sets BN2 for the data packets as the total number of the connector unit are set. Thus, even if a plurality of connector holders are provided and the harness-forming wires are randomly connected with the connectors, a communication speed can quickly follow such an action.

Further, since the data reading interval ②n following the interval On during which the data on the wiring network are outputted in the procedure described with respect to FIG. 18 is set as a data canceling interval in this embodiment, there is an advantage of automatically avoiding a delay caused by the floating capacity of the wiring network.

Further, since the master unit 260 and the channel units 300 can conduct a wireless communication preferably by means of the infrared communication units 264, 304, transmitters and receivers, or the like provided therein in this embodiment, the wire-side connection instructing means (guide lamps 320, etc.) of each station ST and the master unit 260 can be easily connected and disconnected even if one assembling board 100 is conveyed to a plurality of stations ST. Therefore, operability can be remarkably improved.

Furthermore, since the gateway unit 302 of each channel unit 300 forms a gateway for establishing a communication between a plurality of networks, a communication line built with the master unit 260 as a center can be so connected with external networks (e.g. Intranet 351) as to enable a multiplexing communication without establishing the communication conditions between the master unit 260 and the other networks (Intranet 351), thereby enabling various operations to be performed. For example, the data can be remotely taught to and changed in the storage 262b of the master unit 260 by way of the Intranet 351. Further, since the behavior of the wire connection assisting system having the master unit 260 as a center can be monitored as it is via the Intranet 351, supplementary functions of the wire connection assisting system such as maintenance and warnings can be added.

Further, in the so-called mixed production of producing many kinds of subassemblies in the same subassembly line SL (conveyor line), it is not necessary to input pieces of production information of the individual subassemblies in the wire supply tables 40 since the master unit 260 is provided on each assembling board 100 and the information of the single database built in the storage 262b of each master unit 260 can be shared by all the connector units 250 and channel units 300 in all the stations ST. Thus, the preparation for the production of the subassemblies can be considerably made easier. In addition, even if a problem such as a defective product or a trouble occurs on any of the assembling boards 100 while a plurality of assembling boards 100 are being conveyed in the subassembly line SL, the guide lamps of the wire supply tables 40 may be individually controlled by the master units 260 provided on the respective assembling boards 100 and caused to cooperate with the guide lamps 240 of the connector holders 211 provided on the assembling boards 100. Thus, such a problem has no influence on the connecting operations on the other assembling boards 100. From this viewpoint as well, a reduction in the operability can be maximally suppressed.

Further, since the information of the single database is shared and the connecting operations are assisted in all the stations ST, it is not necessary to provide a means for preventing a connection error of the operator by sorting the insulated wires forming the products by colors. As a result, the kinds of the insulated wires as materials can be reduced and the production cost can be reduced.

Accordingly, this embodiment have marvelous effects that large-side subassemblies can be efficiently produced by easily and precisely performing the wire connecting operations set for the respective stations ST on the same assembling board, and that the mixed production can be flexibly dealt with.

Further, the assembling board 100 of this embodiment is provided with a plurafity of temporarily holding jigs 290 for temporarily holding the other ends of the terminal-provided wires W set as free terminals to be connected when the subassembly is assembled into a wiring harness e.g. at a later stage; and the terminal insertion assisting unit 200 is provided for each temporarily holding jig 290 and includes the guide lamp 291 (terminus end instructing means) for instructing the temporarily holding jig 290 when the other end as the free terminal is brought into contact with the touch plate 245. Thus, in the case that the subassembly includes the so-called "free terminals" to be connected when the subassembly is assembled into a wiring harness, suitable temporarily holding positions can be instructed for the individual free terminals upon temporarily holding the free terminals at a plurality of positions, with the result that the wire connecting operation can be efficiently performed.

The above described embodiment is a mere illustration of a preferable example of the present invention, and the present invention is not limited thereto. It should be appreciated that various design changes can be made without departing the scope of the present invention as claimed.

As described above, the present invention has an advantageous effect that the electrical connection test can be conducted within a practical response time every time the harness-forming wire is connected on the compact assembling board.

Moreover, as described above, the wire connection is assisted by adopting the perfect time-division multiplexing communication method according to the present invention. Thus, there is an advantageous effect that the operation of connecting the wires of the wiring harness to form a large-scale circuitry can be easily, precisely and continuously performed on the same assembling board based on the connection assisting information built into the single database.

### LIST OF STANDARD NUMERALS

- 10: wire connection assisting system (example of a processing system)
- 30: assembling board unit
- 40: wire supply table
- 41: channel section
- 100: assembling board
- 200: terminal insertion assisting unit (example of a wire connection instructing mechanism)
- 211: connector holder
- 220: probe (example of a detecting element)
- 240: guide lamp (example of a connector-side connection instructing means)
- 245: touch plate (example of a grounding member)
- 250: connector unit (example of a slave node)
- 262: controller
- 260: master unit (example of a master node)
- 264: infrared communication unit
- 291: guide lamp (example of a terminus end instructing means)
- 300: channel unit (example of a wire-side node unit)
- 304: infrared communication unit
- 320: guide lamp (example of a wire-side connection instructing means)
- B: bus (example of a multiplexing communication path)
- C: connector
- ST: station
- T: terminal
- W: terminal-provided wire (example of a harness-forming wire)

## Claims

1. A wire connection assisting system (10), comprising:
a wire supplying portion (40) for accommodating terminal-provided wires (W) while sorting the terminal-provided wires (W) according to their kinds beforehand,
an assembling board (100) on which the terminal-provided wires (W) taken out from the wire supplying portion (40) are to be connected,
connector holders (211) provided on the assembling board (100) and each including a connector accommodating portion (212) for holding a connector (C) to be connected with the terminal-provided wire (W) taken out from the wire supplying portion (40) and a detecting element (220) electrically connectable with a terminal (T) of the terminal-provided wires (W) inserted into the connector (C) at least partly accommodated in the connector accommodating portion (212),
a wire-side connection instructing means (320) provided at the wire supplying portion (40) for giving an instruction of taking out a specific wire (W) accommodated in the wire supplying portion (40),
connector-side connection instructing means (240) provided in correspondence with the respective connector holders (211) for displaying a connection end corresponding to the connector (C) with which the taken-out terminal-provided wire (W) is to be connected,
a master unit (260) provided on the assembling board (100) to be at least temporarily electrically connectable with the respective detecting elements (220) for controlling the respective connection instructing means (320, 240),
a wire-side node unit (300) at least temporarily connected with the master unit (260) in such a manner as to enable a multiplexing communication and adapted to drive the wire-side connection instructing means (320) based on a control of the master unit (260),
a connector-side node unit (250) at least temporarily connected with the master unit (260) in such a manner as to enable a multiplexing communication and adapted to control the detecting elements (220) of the connector holders (211) and the wire-side connection instructing means (320) based on the control of the master unit (260), and
a multiplexing communication control system (262a, 252a, 302a) for at least temporarily connecting the master unit (260) and the node unit (300, 250) as nodes so as to enable the multiplexing communication therebetween.

2. A wire connection assisting system according to claim 1, wherein the connection of harness-forming wires (W) to form a wiring harness being assisted by controlling (S9) the respective connection instructing means (320, 240) based on an information of a single database (269a; 269b; 269c) built in the master unit (260) and a connection information of the harness-forming wires (W) to be connected with the connectors (C) on the assembling board (100).

3. A wire connection assisting system according to claim 1 or 2, wherein the multiplexing communication system comprises:
a node address setting means (251 b; 251 c, 301 b; 301 c) for setting different node addresses for the respective nodes (250, 300),
a token issuing means (2622) for issuing timing bit sets as token signals (BN) at specified intervals, and
a token reception controller (2521; 2621; 3021) for giving the tokens (BN) to the respective nodes (250; 300) by a time-division technique based on the timing bit sets issued by the token issuing means (2622) and the node addresses.

4. A wire connection assisting system according to claim 1, 2 or 3, wherein the master unit (260) has a function of testing (S20) an electrical connection of a network including the connected harness-forming wire (W) substantially every time the harness-forming wire (W) is connected with the connector (C) at least partly held in the connector holder (211), and causes the respective connection instructing means (320, 240) to assist a next connecting operation only in the case of a success in an electrical connection test (S20).

5. A wire connection assisting system according to claim 4, wherein the wire supplying portion (40) is provided at each of a plurality of stations (ST) installed along a conveyance path along which the assembling board (100) is conveyed, and the master unit (260) tests (S20) the electrical connection up to the last stage of the production process of the wiring harness being tested.

6. A wire connection assisting system according to one or more of the preceding claims 1 to 5, wherein the wire-side node unit (300) comprises a gateway (302) which can conduct a communication, preferably a multiplexing communication with an external network (351).

7. A wire connection assisting system according to one or more of the preceding claims 1 to 6, wherein the assembling board (100) comprises:
a plurality of temporarily holding jigs (290) for temporarily holding the other ends of the terminal-provided wires (W) determined as free terminals to be connected when the subassembly is assembled into the wiring harness preferably at a later stage,
the connector-side node unit (250) is provided for each of the temporarily holding jigs (2909 and is connected with a terminus end instructing means (291) for instructing the temporarily holding jig (290), preferably when the other end as the free terminal (T) is brought into contact with a grounding member (245).

## Patentansprüche

1. Kabel- bzw. Drahtverbindungs-Unterstützungssystem (10), umfassend:
einen Drahtzufuhrabschnitt (40) zum Aufnehmen von mit einem Anschluß versehenen Drähten bzw. Kabeln (W), während die mit einem Anschluß versehenen Drähte (W) entsprechend ihren Arten vorsortiert sind bzw. werden,
eine Zusammenbautafel (100), auf welcher die mit einem Anschluß versehenen Drähte (W), welche aus dem Drahtzufuhrabschnitt (40) entnommen sind, zu verbinden sind,
Verbinderhalter bzw. -halterungen (211), welche auf der Zusammenbautafel (100) zur Verfügung gestellt sind und jeweils einen Verbinder aufnehmenden Abschnitt (212) zum Halten eines Verbinders (C), welcher mit dem mit einem Anschluß versehenen Draht (W) zu verbinden ist, welcher aus dem Drahtzufuhrabschnitt (40) entnommen ist, und ein detektierendes Element (220) beinhalten, welches elektrisch mit einem Anschluß (T) der mit einem Anschluß versehenen Drähte (W) verbindbar ist, welche in den Verbinder (C) eingesetzt sind, welcher wenigstens teilweise in dem einen Verbinder aufnehmenden Abschnitt (212) aufgenommen ist,
drahtseitige Verbindungsinstruktionsmittel (320), welche an dem Drahtzufuhrabschnitt (40) zur Verfügung gestellt sind, um eine Instruktion bzw. Anweisung zum Entnehmen eines bestimmten Drahts (W) zu geben, welcher in dem Drahtzufuhrabschnitt (40) aufgenommen ist,
verbinderseitige Verbindungsinstruktionsmittel (240), welche in Übereinstimmung mit den entsprechenden Verbinderhaltern (211) zur Verfügung gestellt sind, um ein Verbindungsende entsprechend dem Verbinder (C) anzuzeigen, mit welchen der entnommene, mit einem Anschluß versehene Draht (W) zu verbinden ist,
eine Haupt- bzw. Mastereinheit (260), welche auf bzw. an der Zusammenbautafel (100) zur Verfügung gestellt ist, um wenigstens vorübergehend elektrisch mit den entsprechenden detektierenden Elementen (220) für ein Regeln bzw. Steuern bzw. Kontrollieren der entsprechenden Verbindungsinstruktionsmittel (320, 240) verbindbar zu sein,
eine drahtseitige Knoteneinheit (300), welche wenigstens vorübergehend mit der Haupteinheit (260) in einer derartigen Weise verbunden ist, um eine vervielfachende bzw. Multiplexing-Kommunikation zu ermöglichen, und adaptiert ist, um die drahtseitigen Verbindungsinstruktionsmittel (320) basierend auf einer Regelung bzw. Steuerung der Haupteinheit (260) anzutreiben,
eine verbinderseitige Knoteneinheit (250), welche wenigstens vorübergehend mit der Haupteinheit (260) in einer derartigen Weise verbunden ist, um eine Multiplexing-Kommunikation zu ermöglichen, und adaptiert ist, um die detektierenden Elemente (220) der Verbinderhalter (211) und die drahtseitigen Verbindungsinstruktionsmittel (320) basierend auf der Regelung bzw. Steuerung der Haupteinheit (260) zu regeln bzw. zu steuern, und
ein Multiplexing-Kommunikations-Regel- bzw. -Steuersystem (262a, 252a, 302a) für ein wenigstens vorübergehendes Verbinden der Haupteinheit (260) und der Knoteneinheit (300, 250) als Knoten, um die Multiplexing-Kommunikation dazwischen zu ermöglichen.

2. Drahtverbindungs-Unterstützungssystem nach Anspruch 1, wobei die Verbindung von einen Kabelbaum bildenden Drähten (W), um einen Kabelbaum zu bilden, durch ein Regeln bzw. Steuern (S9) der entsprechenden Verbindungsinstruktionsmittel (320, 240) basierend auf einer Information einer einzigen Datenbank (269a; 269b; 269c), welche in der Haupteinheit (260) ein- bzw. aufgebaut ist, und einer Verbindungsinformation der den Kabelbaum bildenden Drähte (W) unterstützt ist bzw. wird, um mit den Verbindern (C) auf der Zusammenbautafel (100) verbunden zu werden.

3. Drahtverbindungs-Unterstützungssystem nach Anspruch 1 oder 2, wobei das Multiplexing-Kommunikationssystem umfaßt:
Knotenadressen-Einstellmittel (251b; 251 c, 301b; 301 c) zum Einstellen bzw. Festlegen von unterschiedlichen Knotenadressen für die entsprechenden Knoten (250, 300),
Token- bzw. Markierungs-Ausgabemittel (2622) zum Ausgeben von Zeitgebungs-Bitsätzen als Markierungs- bzw. Token-Signale (BN) an bestimmten Intervallen, und eine Token-Empfangs-Regel- bzw. -Steuereinrichtung (2521; 2621; 3021) zum Ausgeben der Markierungen bzw. Token (BN) an die entsprechenden Knoten (250; 300) durch eine Zeitunterteilungstechnik basierend auf den Zeitgebungs-Bitsätzen, welche durch die Token-Ausgabemittel (2622) ausgegeben sind, und den Knotenadressen.

4. Drahtverbindungs-Unterstützungssystem nach Anspruch 1, 2 oder 3, wobei die Haupteinheit (260) eine Funktion eines Testens (S20) einer elektrischen Verbindung eines Netzwerks, beinhaltend den verbundenen, einen Kabelbaum bildenden Draht (W), im wesentlichen jedesmal, wenn der den Kabelbaum bildende Draht (W) mit dem Verbinder (C) verbunden ist bzw. wird, welcher wenigstens teilweise in dem Verbinderhalter (211) gehalten ist, aufweist und bewirkt, daß die entsprechenden Verbindungsinstruktionsmittel (320, 240) einen nächsten Verbindungsvorgang nur in dem Fall eines Erfolgs in einem elektrischen Verbindungstest (S20) unterstützen.

5. Drahtverbindungs-Unterstützungssystem nach Anspruch 4, wobei der Drahtzufuhrabschnitt (40) an jeder einer Mehrzahl von Stationen (ST) zur Verfügung gestellt ist, welche entlang eines Förderpfads installiert sind, entlang welchem die Zusammenbautafel (100) gefördert ist bzw. wird, und die Haupteinheit (260) die elektrische Verbindung bis zu der letzten Stufe des Produktionsprozesses des zu testenden Kabelbaums testet (S20).

6. Drahtverbindungs-Unterstützungssystem nach einem oder mehreren der vorangehenden Ansprüche 1 bis 5, wobei die drahtseitige Knoteneinheit (300) ein Gateway (302) umfaßt, welches eine Kommunikation, vorzugsweise eine Multiplexing-Kommunikation mit einem externen Netzwerk (351) durchführen kann.

7. Drahtverbindungs-Unterstützungssystem nach einem oder mehreren der vorangehenden Ansprüche 1 bis 6, wobei die Zusammenbautafel (100) umfaßt:
eine Mehrzahl von vorübergehend haltenden Betätigungselementen bzw. Werkzeugen (290) für ein vorübergehendes Halten der anderen Enden der mit einem Anschluß versehenen Drähte (W), welche als freie Anschlüsse bestimmt sind, um verbunden zu werden, wenn die Sub- bzw. Untereinheit in den Kabelbaum vorzugsweise an einer späteren Stufe zusammengebaut ist bzw. wird,
wobei die verbinderseitige Knoteneinheit (250) für jedes der vorübergehend haltenden Betätigungselemente (290) mit Anschlußende-Instruktionsmitteln (291) für ein Instruieren des vorübergehend haltenden Betätigungselements (290) verbunden ist, vorzugsweise wenn das andere Ende als der freie Anschluß (T) in Kontakt mit einem Erdungsglied (245) gebracht ist bzw. wird.

## Revendications

1. Système d'aide à la connexion de câbles (10), comprenant :
une partie de fourniture de câbles (40) pour contenir des câbles pourvus de bornes (W) tout en triant préalablement les câbles pourvus de bornes (W) en fonction de leurs types,
une table d'assemblage (100) sur laquelle les câbles pourvus de bornes (W) extraits de la partie de fourniture de câbles (40) doivent être connectés,
des montures de connecteur (211) prévues sur la table d'assemblage (100) et comprenant chacune une partie de réception de connecteur (212) pour tenir un connecteur (C) à connecter au câble pourvu de borne (W) extrait de la partie de fourniture de câbles (40), et un élément de détection (220) électriquement connectable à une borne (T) des câbles pourvus de bornes (W) insérée dans le connecteur (C), au moins en partie logé dans la partie de réception de connecteur (212),
un moyen d'instruction de connexion côté câble (320) prévu dans la partie de fourniture de câbles (40), pour donner une instruction d'extraction d'un câble spécifique (W) logé dans la partie de fourniture de câbles (40),
un moyen d'instruction de connexion côté connecteur (240) prévu en correspondance des montures de connecteur respectives (211) pour présenter une extrémité de connexion correspondant au connecteur (C) avec lequel le câble pourvu de borne (W) extrait doit être connecté,
une unité principale (260) prévue sur la table d'assemblage (100) pour être au moins temporairement électriquement connectable aux éléments de détection respectifs (220) pour commander les moyens d'instruction de connexion respectifs (320, 240),
une unité de noeud côté câble (300) au moins temporairement connectée à l'unité principale (260) de manière à permettre une communication de multiplexage, et prévue pour exciter les moyens d'instruction de connexion côté câble (320) sur la base d'une commande de l'unité principale (260),
une unité de noeud côté connecteur (250) au moins temporairement connectée à l'unité principale (260) de manière à permettre une communication de multiplexage, et prévue pour commander les éléments de détection (220) des montures de connecteur (211) et les moyens d'instruction de connexion côté câble (320) sur la base de la commande de l'unité principale (260), et
un système de commande de communication de multiplexage (262a, 252a, 302a) pour connecter au moins temporairement l'unité principale (260) et l'unité de noeud (300, 250) comme des noeuds de façon à permettre la communication de multiplexage entre elles.

2. Système d'aide à la connexion de câbles selon la revendication 1, dans lequel la connexion de câbles de formation de faisceau (W), pour former un faisceau de câblage, est assistée par commande (S9) des moyens d'instruction de connexion respectifs (320, 240) sur la base d'une information d'une base de données unique (269a ; 269b ; 269c) construite dans l'unité principale (260) et d'une information de connexion des câbles de formation de faisceau (W) à connecter aux connecteurs (C) sur la table d'assemblage (100).

3. Système d'aide à la connexion de câbles selon la revendication 1 ou 2, dans lequel le système de communication de multiplexage comprend :
des moyens d'établissement d'adresse de noeud (251b ; 251c, 301b ; 301c) pour établir différentes adresses de noeud pour les noeuds respectifs (250, 300),
des moyens d'émission de jeton (2622) pour émettre des groupes de bits de synchronisation comme signaux de jeton (BN) à intervalles spécifiés, et
un contrôleur de réception de jeton (2521 ; 2621 ; 3021) pour donner les jetons (BN) aux noeuds respectifs (250 ; 300) par une technique de division de temps basée sur les groupes de bits de synchronisation émis par les moyens d'émission de jeton (2622) et les adresses de noeud.

4. Système d'aide à la connexion de câbles selon la revendication 1, 2 ou 3, dans lequel l'unité principale (260) a une fonction de test (S20) d'une connexion électrique d'un réseau incluant le câble de formation de faisceau connecté (W) sensiblement chaque fois que le câble de formation de faisceau (W) est connecté avec le connecteur (C) au moins en partie tenu dans la monture de connecteur (211), et actionne les moyens d'instruction de connexion respectifs (320, 240) pour aider une opération de connexion suivante seulement dans le cas d'un succès dans un test de connexion électrique (S20).

5. Système d'aide à la connexion de câbles selon la revendication 4, dans lequel la partie de fourniture de câbles (40) est prévue à chacune d'une pluralité de stations (ST) installées le long d'un chemin de transport le long duquel la table d'assemblage (100) est transportée, et l'unité principale (260) teste (S20) la connexion électrique jusqu'au dernier stade du processus de production du faisceau de câbles testé.

6. Système d'aide à la connexion de câbles selon une ou plusieurs des revendications précédentes 1 à 5, dans lequel l'unité de noeud côté câble (300) comprend une passerelle (302) qui peut conduire une communication, de préférence une communication de multiplexage, avec un réseau externe (351).

7. Système d'aide à la connexion de câbles selon une ou plusieurs des revendications précédentes 1 à 6, dans lequel la table d'assemblage (100) comprend :
une pluralité d'outils de maintien temporaire (290) pour tenir temporairement les autres extrémités des câbles pourvus de bornes (W) déterminées comme bornes libres à connecter lorsque le sous-ensemble est assemblé dans le faisceau de câbles de préférence à un stade ultérieur,
l'unité de noeud côté connecteur (250) est prévue pour chacun des outils de maintien temporaire (290) et elle est connectée à des moyens d'instruction de fin d'opération (291) pour commander l'outil de maintien temporaire (290), de préférence lorsque l'autre extrémité constituant la borne libre (T) est mise en contact avec un élément de mise à la terre (245).
